# EUROPEAN PATENT APPLICATION

(11) **EP 3 001 776 A1**
(43) Date of publication of application: **30.03.2016**
(21) Application number: 14800992.1
(22) Date of filing: 20.05.2014
(51) Int. Cl.: H05B 33/02, C08F 20/20, C08J 5/18, H01L 51/50

(54) **LIGHT EXTRACTION FILM, METHOD FOR PRODUCING SAME, AND SURFACE LIGHT EMITTING BODY**

(30) Priority: 22.05.2013 JP 2013107868; 28.01.2014 JP 2014013433
(71) Applicant: Mitsubishi Rayon Co., Ltd., Tokyo 100-8253 (JP)
(72) Inventor: YAMADA, Naoko, Yokohama-shi Kanagawa 230-0053 (JP); KURITA, Yusuke, Yokohama-shi Kanagawa 230-0053 (JP); INOUE, Yoshiki, Yokohama-shi Kanagawa 230-0053 (JP)
(74) Representative: TBK
(86) International application number: PCT/JP2014/063318
(87) International publication number: WO 2014/189037

(57) **Abstract**

A light extraction film of the present invention relates to a light extraction film for EL elements, which enables a surface light emitting body to have a sufficiently improved luminance in the normal direction, while being sufficiently suppressed in emission angle dependence of the wavelength of light emitted therefrom. More specifically, the present invention relates to a light extraction film (10) which is laminated on a substrate of an EL element, and which has a recessed and projected structure (13) on the surface. The materials that constitute this light extraction film (10) contain a resin (X) that has at least one skelton selected from among a fluorene skeleton, a biphenyl skeleton and a naphthalene skelton.

## Description

### TECHNICAL FIELD

The present invention relates to a light extraction film, a method for producing the same, and a surface light-emitting body including the light extraction film, and particularly to a technique for light extraction from an organic electroluminescent (EL) element in a surface light-emitting body having an organic EL element as a light emitting source.

### BACKGROUND ART

Among surface light-emitting bodies, an organic EL element is expected to be used in a flat panel display and also in a new generation lighting device that is used in place of a fluorescent bulb and the like.

The structure of the organic EL element is diversified, that is, from a simple structure in which an organic thin film to be a light emitting layer is merely interposed between two films to a multi-layered structure. As an example of the latter multi-layered structure, those obtained by laminating a hole transporting layer, a light emitting layer, an electron transporting layer, and a negative electrode on a positive electrode formed on a glass substrate are exemplified. The layer interposed between the positive electrode and the negative electrode entirely consists of an organic thin film, and the thickness of each organic thin film is extremely thin, that is, only several tens of nm.

The organic EL element is a laminate of thin films, and based on a difference in refractive index between materials of each thin film, the total reflection angle of the light between the thin films is determined. Under the current circumstances, about 80% of the light generated from the light emitting layer is trapped inside the organic EL element and cannot be extracted to the outside. Specifically, when the refractive index of the glass substrate is 1.5 and the refractive index of an air layer is 1.0, a critical angle θc is 41.8° and the light with the incidence angle lower than the critical angle θc is emitted from the glass substrate to the air layer. However, the light with the incidence angle higher than the critical angle θc undergoes total reflection and is trapped inside the glass substrate. For such reasons, it has been desired to achieve a light extracting function of extracting the light trapped inside the glass substrate on the surface of the organic EL element to the outside of the glass substrate, that is, to improve light extraction efficiency and luminance in a normal direction.

Furthermore, regarding an organic EL element which performs isotropic light emission, it is desired to have not only improvement in the light extraction efficiency and the luminance in the normal direction but also a decrease in the emission angle dependence of the wavelength of light emitted from the organic EL element. That is, it is desired to have a small difference in emission angle according to the wavelength when light emitted from the light emitting layer passes through the glass substrate to result in light emission from the glass substrate. In other words, the wavelength dependence of the light distribution emitted from the glass substrate is desired to be as small as possible.

In order to solve the problems described above, Patent Document 1 proposes a surface light-emitting body using, as a film for light extraction, a microlens sheet (an optical film) having a minute unit lens formed by a urethane acrylate resin.

### CITATION LIST

### PATENT DOCUMENT

Patent Document 1: JP 2010-212204 A
Patent Document 2: WO 2008/096748 A

### SUMMARY OF THE INVENTION

### PROBLEM TO BE SOLVED BY THE INVENTION

However, in the surface light-emitting body proposed in Patent Document 1, the luminance in the normal direction and the emission angle dependence of the wavelength of emitted light of the surface light-emitting body are improved, but it cannot be said yet that this improvement is sufficient.

Furthermore, since the film for light extraction proposed in Patent Document 1 has a recessed and projected structure on the film surface, the light extraction efficiency is improved, but since the refractive index of the member is low, the effect of improving the light extraction efficiency is not sufficient.

In this regard, a first object of the invention is to provide a light extraction film for EL which enables sufficient improvement in light extraction efficiency and luminance in the normal direction of a surface light-emitting body and sufficient suppression of emission angle dependence of the wavelength of light emitted from the surface light-emitting body, and to provide a surface light-emitting body in which luminance in the normal direction is sufficiently improved and emission angle dependence of the wavelength of emitted light is sufficiently suppressed.

Incidentally, in order to efficiently extract light emitted from a light emitting layer to the outside of the EL element, using a material having a high refractive index in the light extraction film is considered to be effective. However, since most of resins having a high refractive index have a benzene ring, light resistance is low and the resins become yellow due to ultraviolet ray exposure for a long time, which leads to lowering of the light extraction efficiency or the luminance in the normal direction.

In this regard, a second object of the invention is to provide a light extraction film in which the light extraction efficiency and the luminance in the normal direction of the surface light-emitting body are sufficiently improved and the emission angle dependence of the wavelength of emitted light is sufficiently suppressed, and a change in color due to ultraviolet ray exposure is less likely to occur and which is excellent in long-term stability, and a surface light-emitting body provided with the light extraction film.

### MEANS FOR SOLVING PROBLEM

As a result of intensive studies to achieve the above objects, the present inventors have found that, when, in the light extraction film for EL having a recessed and projected structure on the surface thereof, a resin (X) having at least one skeleton of a fluorene skeleton, a biphenyl skeleton, and a naphthalene skeleton is used in a material constituting the film, it is possible to achieve sufficient improvement in light extraction efficiency and luminance in the normal direction of the surface light-emitting body and sufficient suppression of emission angle dependence of the wavelength of light emitted from the surface light-emitting body, and thus the invention was completed.

As a result of further studies, the present inventors found that, when at least one of an ultraviolet absorber and a photo-stabilizing agent is used, in addition to the resin (X), in the material constituting the light extraction film for EL having a recessed and projected structure on the surface thereof, it is possible to form a light extraction film in which the light extraction efficiency and the luminance in the normal direction of the surface light-emitting body are sufficiently improved and the emission angle dependence of the wavelength of emitted light is sufficiently suppressed, and a change in color due to ultraviolet ray exposure is less likely to occur and which is excellent in long-term stability.

That is, the light extraction film of the invention is a light extraction film which is laminated on a substrate of an EL element, characterized in that the light extraction film has a recessed and projected structure on the surface thereof, and a material constituting the light extraction film contains a resin (X) having at least one skeleton of a fluorene skeleton, a biphenyl skeleton, and a naphthalene skeleton.

In a preferred example of the light extraction film of the invention, at least one of an ultraviolet absorber and a photo-stabilizing agent is contained.

Furthermore, the surface light-emitting body of the invention is characterized by including the light extraction film and an EL element.

Further, the method for producing a light extraction film of the invention is a method for producing a light extraction film which is laminated on a substrate of an EL element, the method characterized by including supplying a monomer composition containing a monomer (x) having at least one skeleton of a fluorene skeleton, a biphenyl skeleton, and a naphthalene skeleton to a space between a base material and a mold having a transferring portion of a recessed and projected structure, and curing the monomer composition.

### EFFECT OF THE INVENTION

According to the light extraction film of the invention, when the resin (X) having at least one skeleton of a fluorene skeleton, a biphenyl skeleton, and a naphthalene skeleton is used in the material constituting the light extraction film for EL having a recessed and projected structure on the surface thereof, it is possible to provide a light extraction film for EL which enables sufficient improvement in light extraction efficiency and luminance in the normal direction of a surface light-emitting body and sufficient suppression of emission angle dependence of the wavelength of light emitted from the surface light-emitting body. Furthermore, when such a light extraction film is used, it is possible to provide a surface light-emitting body in which light extraction efficiency and luminance in the normal direction are sufficiently improved and emission angle dependence of the wavelength of emitted light is sufficiently suppressed.

According to the light extraction film of the invention, when at least one of an ultraviolet absorber and a photo-stabilizing agent is used in addition to the resin (X), it is possible to provide a light extraction film in which the light extraction efficiency and the luminance in the normal direction of the surface light-emitting body are sufficiently improved and the emission angle dependence of the wavelength of emitted light is sufficiently suppressed, and a change in color due to ultraviolet ray exposure is less likely to occur and which is excellent in long-term stability.

### BRIEF DESCRIPTION OF DRAWINGS

Fig. 1 is a schematic diagram illustrating an example of a cross section of a light extraction film of the invention;
Fig. 2 is a schematic diagram illustrating an arrangement example of a recessed and projected structure of the light extraction film of the invention when viewed from the upper side of the light extraction film;
Fig. 3 is a schematic diagram illustrating an example of the recessed and projected structure of the light extraction film of the invention;
Fig. 4 is a schematic diagram illustrating an example of the light extraction film of the invention when viewed from the upper side of the light extraction film;
Fig. 5 is a schematic diagram illustrating an example of a method for producing a light extraction film of the invention; and
Fig. 6 is a schematic diagram illustrating an example of a cross section of a surface light-emitting body of the invention.

### MODE(S) FOR CARRYING OUT THE INVENTION

Hereinafter, an embodiment of the invention will be described with reference to the drawings, but the invention is not limited to these drawings.

### (Light Extraction Film 10)

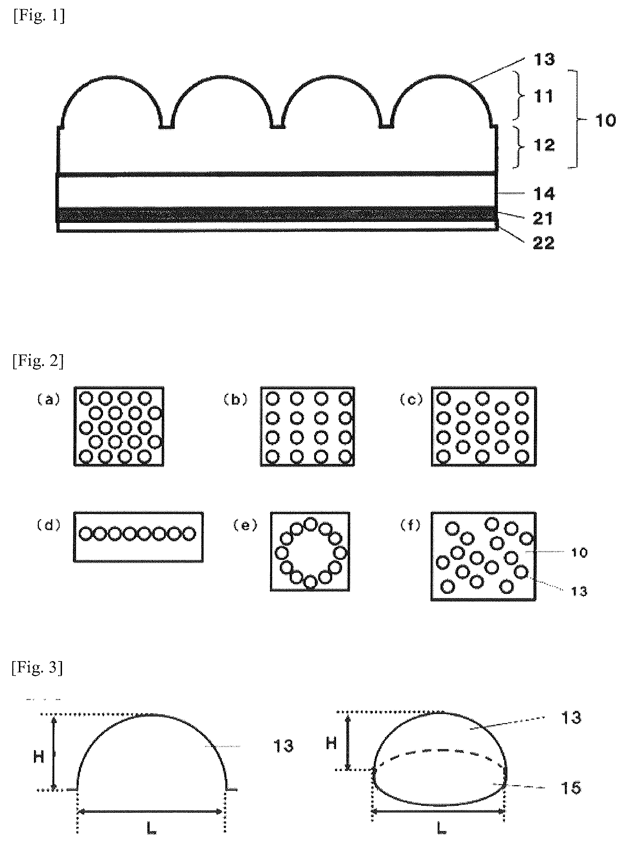

The light extraction film of the invention is a light extraction film which is laminated on a substrate of an EL element, and for example, a light extraction film 10 as illustrated in Fig. 1 is exemplified. By combination with an EL element (specifically, an organic EL element) as a light emitting source, the light extraction film 10 exhibits a function of extracting light from the EL element.

The light extraction film 10 has a recessed and projected structure 13 on the surface thereof. It is preferable that the light extraction film 10 having a base layer 12 and a recessed and projected structure layer 11 be formed by sequentially laminating the base layer 12 and the recessed and projected structure layer 11 having the recessed and projected structure 13 on one surface (an upper surface) of a base material 14, from the viewpoint that continuous production of the light extraction film 10 can be easily performed and the light extraction film 10 is excellent in structure stability (specifically, the maintaining of the shape of the recessed and projected structure 13) and handlability.

In the light extraction film of the invention, it is necessary for a material constituting the light extraction film to contain a resin (X) having at least one skeleton of a fluorene skeleton, a biphenyl skeleton, and a naphthalene skeleton. When such a resin (X) is used, it is possible to achieve sufficient improvement in light extraction efficiency and luminance in the normal direction of the surface light-emitting body and sufficient suppression of emission angle dependence of the wavelength of light emitted from the surface light-emitting body. The resin (X) has a higher refractive index than those of general resins, and when the resin (X) is contained in the light extraction film 10, it is possible to improve the light extraction efficiency and the luminance in the normal direction of the surface light-emitting body.

In the light extraction film of the invention, from the viewpoint that the light extraction efficiency and the luminance in the normal direction of the surface light-emitting body are further improved and the emission angle dependence of the wavelength of light emitted from the surface light-emitting body is further suppressed, the content ratio of the resin (X) in the material constituting the light extraction film is preferably 30% by mass or more, even more preferably 50% by mass or more, and further preferably in the range of 75 to 99% by mass.

### (Resin (X))

The resin (X) has at least one skeleton of a fluorene skeleton, a biphenyl skeleton, and a naphthalene skeleton. However, here, when the resin (X) has a fluorene skeleton, a resin having a fluorene skeleton contains a fluorene structure, that is, a constituent unit represented by the following Formula (1).

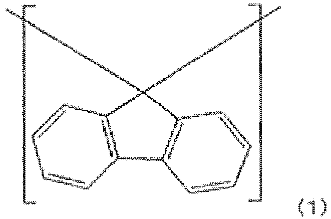

The resin having a fluorene skeleton is preferably a resin with a high light transmittance in the wavelength range of visible light (about 400 to 700 nm). Specifically, the light transmittance of the resin having a fluorene skeleton is preferably 50 to 95% and more preferably 60 to 90%, from the viewpoint of having excellent appearance of the light extraction film 10 and excellent light extraction efficiency or luminance in the normal direction of the surface light-emitting body.

Incidentally, a value measured in conformity with JIS K7361 is set as the light transmittance.

Furthermore, when the resin (X) has a biphenyl skeleton, a resin having a biphenyl skeleton contains a constituent unit derived from biphenyl, that is, a constituent unit represented by the following Formula (2).

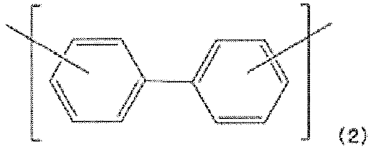

Meanwhile, when the resin (X) has a naphthalene skeleton, a resin having a naphthalene skeleton contains a constituent unit derived from naphthalene, that is, a constituent unit represented by the following Formula (3).

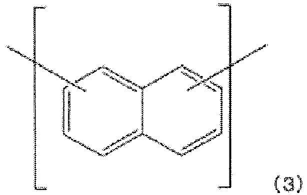

Incidentally, the resin (X) may have one kind of these skeletons alone or may have a combination of two or more kinds thereof.

Furthermore, the resin (X) is preferably a resin containing a constituent unit represented by the following Formula (4), from the viewpoint of having excellent productivity of the light extraction film 10 and the viewpoint of further improving the light extraction efficiency and the luminance in the normal direction of the surface light-emitting body and further improving suppression of the emission angle dependence of the wavelength of light emitted from the surface light-emitting body.

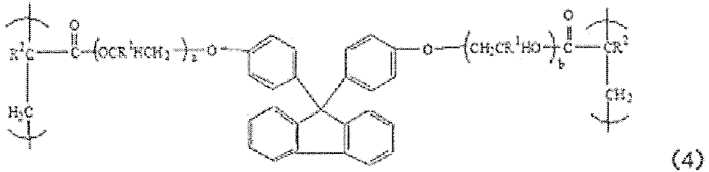

(In the formula, R¹ and R² each independently represent a hydrogen atom or a methyl group, and a and b each independently represent an integer of 0 to 4.)

The content ratio of the constituent unit represented by Formula (4) in the resin (X) is preferably 30 to 99% by mass and more preferably 50 to 95% by mass, from the viewpoint of further improving the light extraction efficiency and the luminance in the normal direction of the surface light-emitting body and further suppressing the emission angle dependence of the wavelength of light emitted from the surface light-emitting body.

The fluorene skeleton, the biphenyl skeleton, and the naphthalene skeleton, that is, the constituent unit derived from fluorene, the constituent unit derived from biphenyl, and the constituent unit derived from naphthalene can be incorporated into various resins. Examples of the various resins include an acrylic resin; a polycarbonate resin; a polyester resin; and a polyvinyl alcohol resin. One kind of these various resins may be used or two or more kinds thereof may be used in combination. Among these various resins, an acrylic resin is preferable, from the viewpoint of having a high light transmittance in the wavelength range of visible light and excellent heat resistance, dynamic properties, and molding processability.

The resin (X) may contain other constituent units to the extent that the performance of the light extraction film 10 is not impaired, in addition to the constituent unit derived from fluorene, the constituent unit derived from biphenyl, and the constituent unit derived from naphthalene.

Examples of the other constituent units include a polyoxyalkylene glycol di(meth)acrylate unit, a polyester polyol di(meth)acrylate unit, and an aromatic ester diol di(meth)acrylate unit, but the resin (X) can contain one kind of these constituent units alone or a combination of two or more kinds thereof.

Incidentally, from the viewpoint of improving the flexibility of the light extraction film 10, a polyoxyalkylene glycol di(meth)acrylate unit, a polyester polyol di(meth)acrylate unit, and an aromatic ester diol di(meth)acrylate unit are preferable, and a polyoxyalkylene glycol di(meth)acrylate unit is more preferable.

The content ratio (in a case where the resin (X) contains a plurality of units, the total content) of the polyoxyalkylene glycol di(meth)acrylate unit, the polyester polyol di(meth)acrylate unit, and the aromatic ester diol di(meth)acrylate unit in the resin (X) is preferably 1 to 70% by mass and more preferably 5 to 50% by mass, from the viewpoint of improving the flexibility of the light extraction film 10.

In the light extraction film of the invention, it is preferable that the material constituting the light extraction film further contain at least one of an ultraviolet absorber and a photo-stabilizing agent. When the ultraviolet absorber or the photo-stabilizing agent is used, it is possible to provide a light extraction film which is less likely to be changed in color due to ultraviolet ray exposure and is excellent in long-term stability.

Here, in the light extraction film of the invention, from the viewpoint that the change in color due to ultraviolet ray exposure can be suppressed and the viewpoint of having excellent long-term stability, the content ratio of the ultraviolet absorber in the material constituting the light extraction film is preferably 0.1% by mass or more, even more preferably 0.5% by mass or more, and further preferably 1% by mass or more. Incidentally, the upper limit of the content ratio of the ultraviolet absorber in the material constituting the light extraction film is preferably 20% by mass and more preferably 16% by mass.

Furthermore, in the light extraction film of the invention, from the viewpoint that the change in color due to ultraviolet ray exposure can be suppressed and the viewpoint of having excellent long-term stability, the content ratio of the photo-stabilizing agent in the material constituting the light extraction film is preferably 0.1% by mass or more, even more preferably 0.5% by mass or more, and further preferably 1% by mass or more. Incidentally, the upper limit of the content ratio of the photo-stabilizing agent in the material constituting the light extraction film is preferably 20% by mass and more preferably 9% by mass.

### (Ultraviolet Absorber)

Since the ultraviolet absorber has a function of absorbing ultraviolet rays and absorbs ultraviolet rays by sunlight or the like which are incident from the outside, it is possible to suppress the change in color of the light extraction film 10 due to ultraviolet ray exposure and the light extraction film 10 has excellent long-term stability.

Examples of the ultraviolet absorber include benzotriazole-based compounds such as 2-(2-hydroxy-5-t-butylphenyl)-2H-benzotriazole, a C7 to C9 side chain and straight chain alkyl ester of benzene propanoic acid-3-(2H-benzotriazole-2-yl)-5-(1,1-dimethylethyl)-4-hydroxy, 2-(2H-benzotriazole-2-yl)-4,6-bis(1-methyl-1-phenylethyl)phenol, and 2-(2H-benzotriazole-2-yl)-6-(1-methyl-1-phenylethyl)-4-(1,1,3,3-tetramethylbutyl)phenol; hydroxyphenoltriazine-based compounds of hydroxyphenoltriazine and the like such as a reaction product of 2-(4,6-bis(2,4-dimethylphenyl)-1,3,5-triazine-2-yl)-5-hydroxyphenyl and oxirane (for example, ((C10 to C16 alkyloxy)methyl)oxirane), a reaction product of 2-(2,4-dihydroxyphenyl)-4,6-bis-(2,4-dimethylphenyl)-1,3,5-triazine and (2-ethylhexyl)-glycidic ester, and 2,4-bis(2-hydroxy-4-butoxyphenyl)-6-(2,4-dibutoxyphenyl)-1,3,5-triazine; and benzophenone-based compounds such as 2,4-dihydroxybenzophenone, 2,2-dihydroxy-4-methoxybenzophenone, 2,2'-dihydroxy-4,4'-dimethoxybenzophenone, 2,2',4,4'-tetrahydroxybenzophenone, 2-hydroxy-4-methoxybenzophenone, 2-hydroxy-4-methoxy-4'-methylbenzophenone, 2-hydroxy-4-methoxybenzophenone-5-sulfonate, 4-phenylbenzophenone, 2-ethylhexyl-4'-phenyl-benzophenone-2-carboxylate, 2-hydroxy-4-n-octoxybenzophenone, and 4-hydroxy-3-carboxybenzophenone. These ultraviolet absorbers may be used alone or in combination of two or more kinds thereof. Among these ultraviolet absorbers, from the viewpoint that the change in color of the resin (X) can be suppressed, benzotriazole-based compounds and hydroxyphenoltriazine-based compounds are preferable, and when an active energy ray curable composition to be described later is used, from the viewpoint that a polymerization initiator is efficiently cleaved by a difference in absorption wavelength and the viewpoint of having an excellent curing property, benzotriazole-based compounds are more preferable.

### (Photo-Stabilizing Agent)

Since the photo-stabilizing agent has a function of trapping radicals and traps radicals generated by incident ultraviolet rays of sunlight and the like, it is possible to suppress the change in color of the light extraction film 10 due to chemical construction change and the light extraction film 10 has excellent long-term stability.

Examples of the photo-stabilizing agent include hindered amine compounds such as tetrakis(1,2,2,6,6-pentamethyl-4-piperidinyl)butane-1,2,3,4-tetracarboxylate, tetrakis(2,2,6,6-tetramethyl-4-piperidinyl)butane-1,2,3,4-tetracarboxylate, bis(1,2,2,6,6-pentamethyl-4-piperidyl) ((3,5-bis(1,1-dimetliylethyl)-4-hydroxyphenyl)methyl)butylmalonate, bis(1,2,2,6,6-pentamethyl-4-piperidyl)sebacate, 1,2,2,6,6-pentamethyl-4-piperidylsebacate, decanedioic bis(2,2,6,6-tetramethyl-1-(octyloxy)-4-piperidinyl)ester, a reaction product of 1,1-dimethylethylhydroperoxide and octane, and N,N',N",N'"-tetrakis-(4,6-bis(butyl(N-methyl-2,2,6,6-tetramethylpiperidin-4-yl)amino)triazine-2-yl)-4,7-diazadecane-1,10-diamine. These photo-stabilizing agents may be used alone or in combination of two or more kinds thereof. Among these photo-stabilizing agents, from the viewpoint of having excellent radical trapping capability, hindered amine compounds are preferable, a compound having a nitroxy ether group is more preferable, and decanedioic bis(2,2,6,6-tetramethyl-1-(octyloxy)-4-piperidinyl)ester and a reaction product of 1,1-dimethylethylhydroperoxide and octane are even more preferable.

In the light extraction film of the invention, the material constituting the light extraction film may contain other components to the extent that the performance of the light extraction film 10 is not impaired, in addition to the resin (X), the ultraviolet absorber, and the photo-stabilizing agent.

Examples of the other components include various additives such as a light diffusion fine particle, a flexibility, enhancer, a viscosity modifier, a plasticizer, a filler, a flame retardant, an antistatic agent, an antioxidizing agent, a colorant such as a dye or a pigment, a release agent, a leveling agent, an anti-fouling performance enhancer, and a dispersion stabilizer.

Incidentally, in the light extraction film of the invention, the content ratio of the light diffusion fine particles in the material constituting the light extraction film is preferably 20% by mass or less, more preferably 10% by mass or less, and even more preferably 0% by mass, from the viewpoint of suppressing the warpage of the light extraction film 10.

### (Monomer Composition)

In the light extraction film of the invention, the above-described material constituting the light extraction film is preferably formed by a monomer composition containing a monomer (x) having at least one skeleton of a fluorene skeleton, a biphenyl skeleton, and a naphthalene skeleton. Incidentally, the monomer (x) may be used alone or in combination of two or more kinds thereof. Furthermore, in the invention, the resin (X) can be synthesized by polymerization of the monomer (x) contained in the monomer composition and a monomer, which may be contained as necessary, other than the monomer (x).

The monomer composition is preferably an active energy ray curable monomer composition which may be cured by irradiation of an active energy ray, from the viewpoint that the recessed and projected structure of the light extraction film 10 can be easily formed and continuous production thereof can be easily performed.

Examples of the active energy ray include ultraviolet rays, electron beams, X rays, infrared rays, and visible rays. Among these active energy rays, from the viewpoint of having an excellent curing property of an active energy ray curable monomer composition and the viewpoint that deterioration of the light extraction film 10 can be suppressed, ultraviolet rays and electron beams are preferable, and ultraviolet rays are more preferable.

The active energy ray curable monomer composition is not particularly limited as long as it can be cured by the active energy ray. However, from the viewpoint of having excellent handlability or an excellent curing property and having various excellent physical properties of the light extraction film 10 such as flexibility, heat resistance, abrasion resistance, solvent resistance, light resistance, and a light transmitting property, the active energy ray curable monomer composition preferably contains the monomer (x), monomers (a cross-linkable monomer (a) and a non-cross-linkable monomer (b)) other than the monomer (x), and a polymerization initiator (c). Further, the active energy ray curable monomer composition preferably contains at least one of an ultraviolet absorber and a photo-stabilizing agent.

The monomer having a fluorene skeleton among the monomers (x) contains a fluorene structure, that is, a constituent unit represented by the following Formula (1).

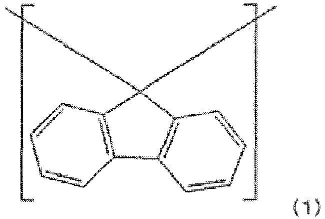

Furthermore, the monomer having a biphenyl skeleton contains a constituent unit derived from biphenyl, that is, a constituent unit represented by the following Formula (2).

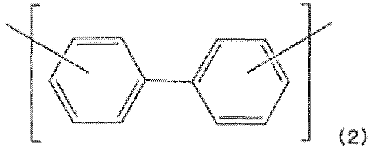

Meanwhile, the monomer having a naphthalene skeleton contains a constituent unit derived from naphthalene, that is, a constituent unit represented by the following Formula (3).

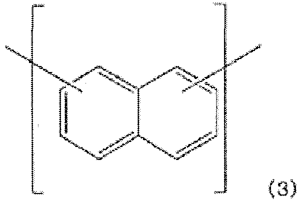

Incidentally, the monomer (x) may have one kind of these skeletons alone or may have a combination of two or more kinds thereof.

Examples of the monomer (x) include fluorene acrylate-based monomers such as fluorene di(meth)acrylate, ethylene oxide-modified fluorene di(meth)acrylate, propylene oxide-modified fluorene di(meth)acrylate, 2-hydroxypropylene oxide-modified fluorene di(meth)acrylate, butylene oxide-modified fluorene di(meth)acrylate, bisphenol fluorene di(meth)acrylate, bisphenoxy ethanol fluorene (meth)acrylate, ethylene oxide-modified bisphenol fluorene di(meth)acrylate, propylene oxide-modified bisphenol fluorene di(meth)acrylate, 2-hydroxypropylene oxide-modified bisphenol fluorene di(meth)acrylate, butylene oxide-modified bisphenol fluorene di(meth)acrylate, bisnaphthol fluorene di(meth)acrylate, bisnaphthoxy ethanol fluorene (meth)acrylate, ethylene oxide-modified bisnaphthol fluorene di(meth)acrylate, propylene oxide-modified bisnaphthol fluorene di(meth)acrylate, 2-hydroxypropylene oxide-modified bisnaphthol fluorene di(meth)acrylate, and butylene oxide-modified bisnaphthol fluorene di(meth)acrylate. These monomers (x) may be used alone or in combination of two or more kinds thereof. Among these monomers (x), from the viewpoint of having excellent handlability or an excellent curing property of an active energy ray curable monomer composition, various excellent physical properties of the light extraction film 10 such as heat resistance, abrasion resistance, solvent resistance, light resistance, and a light transmitting property, and excellent light extraction efficiency or luminance in the normal direction of the surface light-emitting body, a fluorene acrylate-based monomer is preferable, and bisphenol fluorene di(meth)acrylates and bisnaphthol fluorene di(meth)acrylates are more preferable.

Incidentally, in the present specification, (meth)acrylate refers to acrylate or methacrylate.

Furthermore, the monomer (x) is preferably a monomer represented by the following Formula (5), from the viewpoint of having excellent productivity of the light extraction film and the viewpoint of further improving the light extraction efficiency and the luminance in the normal direction of the surface light-emitting body and further improving suppression of the emission angle dependence of the wavelength of light emitted from the surface light-emitting body.

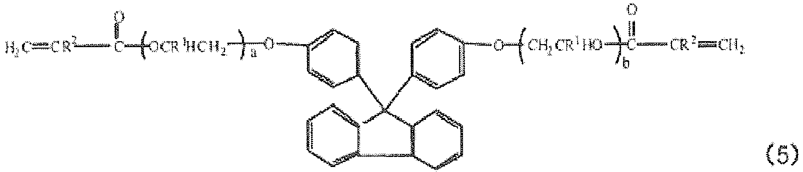

(In the formula, R¹ and R² each independently represent a hydrogen atom or a methyl group, and a and b each independently represent an integer of 0 to 4.)

Examples of the cross-linkable monomer (a) include hexa(meth)acrylates such as dipentaerythritol hexa(meth)acrylate and caprolactone-modified dipentaerythritol hexa(meth)acrylate; penta(meth)acrylates such as dipentaerythritol hydroxy penta(meth)acrylate and caprolactone-modified dipentaerythritol hydroxy penta(meth)acrylate; tetra(meth)acrylates such as ditrimethylolpropane tetra(meth)acrylate, pentaerythritol tetra(meth)acrylate, pentaerythritol methoxy-modified tetra(meth)acrylate, dipentaerythtol hexa(meth)acrylate, dipentaerythtol penta(meth)acrylate, and tetramethylolmethane tetra(meth)acrylate; tri(meth)acrylates such as trimethylol propane tri(meth)acrylate, trisethoxylated trimethylol propane tri(meth)acrylate, pentaerythritol tri(meth)acrylate, ethoxylated pentaerythritol tri(meth)acrylate, tris(2-(meth)acryloyloxyethyl)isocyanurate, trimethylol propane tri(meth)acrylate modified with aliphatic hydrocarbon with 2 to 5 carbon atoms, and isocyanuric acid ethylene oxide-modified tri(meth)acrylate; di(meth)acrylates such as triethylene glycol di(meth)acrylate, diethylene glycol di(meth)acrylate, 1,3-butylene glycol di(meth)acrylate, 1,4-butanediol di(meth)acrylate, 1,5-pentanediol di(metl)acrylate, 1,6-hexanediol di(meth)acrylate, nonane diol di(meth)acrylate, neopentyl glycol di(meth)acrylate, methylpentanediol di(meth)acrylate, diethylpentanediol di(meth)acrylate, hydroxypyvalic acid neopentyl glycol di(meth)acrylate, tetraethylene glycol di(meth)acrylate, tripropylene glycol di(meth)acrylate, polybutylene glycol di(meth)acrylate, tricyclodecane dimethanol di(meth)acrylate, 2,2-bis(4-(meth)acryloxypolyethoxyphenyl)propane, 2,2-bis(4-(meth)acryloxyethoxyphenyl)propane, 2,2-bis(4-(3-(meth)acryloxy-2-hydroxypropoxy)phenyl)propane, 1,2-bis(3-(meth)acryloxy-2-hydroxypropoxy)ethane, 1,4-bis(3-(meth)acryloxy-2-hydroxypropoxy)butane, bis(2-(meth)acryloyloxyethyl)-2-hydroxyethylisocyanurate, cyclohexane dimethanol di(meth)acrylate, dimethylol tricyclodecane di(meth)acrylate, hydroxypyvalic acid neopentyl glycol di(meth)acrylate, polyethoxylated cyclohexane dimethanol di(meth)acrylate, polypropoxylated cyclohexane dimethanol di(meth)acrylate, polyethoxylated bisphenol A di(meth)acrylate, polypropoxylated bisphenol A di(meth)acrylate, hydrogenated bisphenol A di(meth)acrylate, polyethoxylated hydrogenated bisphenol A di(meth)acrylate, polypropoxylated hydrogenated bisphenol A di(meth)acrylate, neopentyl glycol-modified trimethylol propane di(meth)acrylate, di(meth)acrylate of ε-caprolactone adduct of hydroxypyvalic acid neopentyl glycol, di(meth)acrylate of γ-butyrolactone adduct of hydroxypyvalic acid neopentyl glycol, di(meth)acrylate of caprolactone adduct of neopentyl glycol, di(meth)acrylate of caprolactone adduct of butylene glycol, di(meth)acrylate of caprolactone adduct of cyclohexane dimethanol, di(meth)acrylate of caprolactone adduct of dicyclopentanediol, di(meth)acrylate of ethylene oxide adduct of bisphenol A, di(meth)acrylate of propylene oxide adduct of bisphenol A, di(meth)acrylate of caprolactone adduct of bisphenol A, di(meth)acrylate of caprolactone adduct of hydrogenated bisphenol A, di(meth)acrylate of caprolactone adduct of bisphenol F, and isocyanuric acid ethylene oxide-modified di(meth)acrylate; diallyls such as diallylphthalate, diallylterephthalate, diallylisophthalate, and diethylene glycol diallylcarbonate; allyl(meth)acrylate; divinyl benzene; methylene bisacrylamide; polyester di(meth)acrylates such as a compound obtained by a reaction between polybasic acid (phthalic acid, succinic acid, hexahydrophthalic acid, tetrahydrophthalic acid, terephthalic acid, azelaic acid, adipic acid, or the like), polyhydric alcohol (ethylene glycol, hexanediol, polyethylene glycol, polytetramethylene glycol, or the like), and (meth)acrylic acid or derivatives thereof; urethane polyfunctional (meth)acrylates such as a compound obtained by a reaction between a diisocyanate compound (tolylene diisocyanate, isophorone diisocyanate, xylene diisocyanate, dicyclohexylmethane diisocyanate, hexamethylene diisocyanate, or the like) and a hydroxyl group-containing (meth)acrylate (polyfunctional(meth)acrylate such as 2-hydroxyethyl(meth)acrylate, 2-hydroxypropyl(meth)acrylate, 4-hydroxybutyl(meth)acrylate, or pentaerythritol tri(meth)acrylate) and a compound obtained by reacting a hydroxyl group-containing (meth)acrylate with an isocyanate group which has been left after adding a diisocyanate compound to a hydroxyl group of alcohols (one or two or more types of alkane diol, polyether diol, polyester diol, and a spiroglycol compound); divinyl ethers such as diethylene glycol divinyl ether and triethylene glycol divinyl ether; and dienes such as butadiene, isoprene, and dimethyl butadiene. These cross-linkable monomers (a) may be used alone or in combination of two or more kinds thereof. Among these cross-linkable monomers (a), from the viewpoint of having various excellent physical properties of the light extraction film 10 such as flexibility, heat resistance, abrasion resistance, solvent resistance, and a light transmitting property, hexa(meth)acrylates, penta(meth)acrylates, tetra(meth)acrylates, tri(meth)acrylates, di(meth)acrylates, diallyls, allyl(meth)acrylate, polyester di(meth)acrylates, and urethane polyfunctional (meth)acrylates are preferable, and hexa(meth)acrylates, penta(meth)acrylates, tetra(meth)acrylates, tri(meth)acrylates, di(meth)acrylates, polyester di(meth)acrylates, and urethane polyfunctional (meth)acrylates are more preferable.

Incidentally, in the cross-linkable monomer (a), the monomer (x) is excluded.

Examples of the non-cross-linkable monomer (b) include (meth)acrylates such as methyl(meth)acrylate, ethyl(meth)acrylate, n-propyl(meth)acrylate, isopropyl(meth)acrylate, n-butyl(meth)acrylate, iso-butyl(meth)acrylate, sec-butyl(meth)acrylate, tert-butyl(meth)acrylate, n-hexyl(meth)acrylate, cyclohexyl(meth)acrylate, n-octyl(meth)acrylate, 2-ethylhexyl(meth)acrylate, dodecyl(meth)acrylate, tridecyl(meth)acrylate, stearyl(meth)acrylate, alkyl(meth)acrylate, phenyl(meth)acrylate, benzyl(meth)acrylate, phenoxyethyl(meth)acrylate, phenylphenol(meth)acrylate, ethoxyphenylphenol(meth)acrylate, isobomyl(meth)acrylate, glycidyl(meth)acrylate, tetrahydrofurfuryl(meth)acrylate, norbomyl(meth)acrylate, adamantyl(meth)acrylate, dicyclopentenyl(meth)acrylate, dicyclopentanyl(meth)acrylate, tetracyclododecanyl(meth)acrylate, cyclohexane dimethanol mono(meth)acrylate, 2-hydroxyethyl(meth)acrylate, 2-hydroxypropyl(meth)acrylate, 3-hydroxypropyl(meth)acrylate, 2-hydroxybutyl(meth)acrylate, 3-hydroxybutyl(meth)acrylate, 4-hydroxybutyl(meth)acrylate, 2-methoxyethyl(meth)acrylate, 2-ethoxyethyl(meth)acrylate, 3-methoxybutyl(meth)acrylate, butoxyethyl(meth)acrylate, methoxytriethylene glycol (meth)acrylate, methoxydipropylene glycol(meth)acrylate, 2-(meth)acryloyloxymethyl-2-methylbicycloheptane, 4-(meth)acryloyloxymethyl-2-methyl-2-ethyl-1,3-dioxolane, 4-(meth)acryloyloxymethyl-2-methyl-2-isobutyl-1,3-dioxolane, trimethylol propaneformal(meth)acrylate, ethylene oxide-modified phosphoric acid (meth)acrylate, and caprolactone-modified phosphoric acid (meth)acrylate; (meth)acrylic acid; (meth)acrylonitrile; (meth)acrylamides such as (meth)acrylamide, N-dimethyl(meth)acrylamide, N-diethyl(meth)acrylamide, N-butyl(meth)acrylamide, dimethylaminopropyl(meth)acrylamide, N-methylol(meth)acrylamide, N-methoxymethyl(meth)acrylamide, N-butoxymethyl(meth)acrylamide, (meth)acryloylmorpholine, hydroxyethyl(meth)acrylamide, and methylene bis(meth)acrylamide; epoxy(meth)acrylates such as a compound resulting from reaction of (meth)acrylic acid or derivatives thereof with a bisphenol type epoxy resin obtained by condensation reaction between bisphenols (bisphenol A, bisphenol F, bisphenol S, tetrabromo bisphenol A, and the like) and epichlorohydrin; aromatic vinyls such as styrene and α-methyl styrene; vinyl ethers such as vinyl methyl ether, vinyl ethyl ether, and 2-hydroxyethyl vinyl ether; vinyl carboxylates such as vinyl acetate and vinyl butyrate; and olefins such as ethylene, propylene, butene, and isobutene. These non-cross-linkable monomers (b) may be used alone or in combination of two or more kinds thereof. Among these non-cross-linkable monomers (b), from the viewpoint of having excellent handlability or an excellent curing property of an active energy ray curable monomer composition and having various excellent physical properties of the light extraction film 10 such as flexibility, heat resistance, abrasion resistance, solvent resistance, and a light transmitting property, (meth)acrylates, epoxy(meth)acrylates, aromatic vinyls, and olefins are preferable, and (meth)acrylates and epoxy(meth)acrylates are more preferable.

Incidentally, in the non-cross-linkable monomer (b), the monomer (x) and the cross-linkable monomer (a) are excluded.

Examples of the polymerization initiator (c) include carbonyl compounds such as benzoin, benzoin methyl ether, benzoin ethyl ether, benzoin isopropyl ether, benzoin isobutyl ether, acetoin, benzyl, benzophenone, p-methoxybenzophenone, 2,2-diethoxyacetophenone, α,α-dimethoxy-α-phenylacetophenone, benzyl dimethyl ketal, methylphenyl glyoxylate, ethylphenyl glyoxylate, 4,4'-bis(dimethylamino)benzophenone, 1-hydroxycyclohexyl phenyl ketone, 2-hydroxy-2-methyl-1-phenylpropan-1-one, and 2-ethyl anthraquinone; sulfur compounds such as tetramethylthiuram monosulfide and tetramethylthiuram disulfide; and acyl phosphine oxides such as 2,4,6-trimethylbenzoyl diphenylphosphine oxide and benzoyldiethoxy phosphine oxide. These polymerization initiators (c) may be used alone or in combination of two or more kinds thereof. Among these polymerization initiators (c), from the viewpoint of having excellent handlability or an excellent curing property of an active energy ray curable monomer composition and an excellent light transmitting property of the light extraction film 10, carbonyl compounds and acyl phosphine oxides are preferable, and when a benzotriazole-based compound is used for an ultraviolet absorber, from the viewpoint that the benzotriazole-based compound absorbs light of 400 nm or less and the active energy ray curable monomer composition can be efficiently cured at light of 400 nm or more, acyl phosphine oxides are more preferable.

The active energy ray curable monomer composition may contain other components to the extent that the performance of the light extraction film 10 is not impaired, in addition to the monomer (x), monomers (the cross-linkable monomer (a) and the non-cross-linkable monomer (b)) other than the monomer (x), the polymerization initiator (c), the ultraviolet absorber, and the photo-stabilizing agent.

Examples of the other components include various additives such as a light diffusion fine particle, a flexibility enhancer, a viscosity modifier, a plasticizer, a filler, a flame retardant, an antistatic agent, an antioxidizing agent, a colorant such as a dye or a pigment, a release agent, a leveling agent, an anti-fouling performance enhancer, and a dispersion stabilizer.

The content ratio of the monomer (x) in the active energy ray curable monomer composition is preferably 20 to 93% by mass, more preferably 25 to 89% by mass, and even more preferably 30 to 86% by mass in the total amount of the monomer composition. When the content ratio of the monomer (x) is 20% by mass or more, the light extraction efficiency or the luminance in the normal direction of the surface light-emitting body is excellent. Furthermore, when the content ratio of the monomer (x) is 30% by mass or more, the light extraction efficiency or the luminance in the normal direction of the surface light-emitting body is further more excellent. Further, when the content ratio of the monomer (x) is 93% by mass or less, the handlability of an active energy ray curable composition is excellent.

The content ratio of the cross-linkable monomer (a) in the active energy ray curable monomer composition is preferably 5 to 60% by mass, more preferably 8 to 55% by mass, and even more preferably 10 to 50% by mass in the total amount of the monomer composition. When the content ratio of the cross-linkable monomer (a) is 5% by mass or more, the cross-linking property of the monomer composition is excellent and the flexibility of the light extraction film 10 is excellent. Furthermore, when the content ratio of the cross-linkable monomer (a) is 60% by mass or less, the adhesiveness between the light extraction film 10 and the base material 14 is excellent and the light extraction efficiency or the luminance in the normal direction of the surface light-emitting body is excellent.

The content ratio of the non-cross-linkable monomer (b) in the active energy ray curable monomer composition is preferably 1 to 60% by mass, more preferably 2 to 55% by mass, and even more preferably 3 to 50% by mass in the total amount of the monomer composition. When the content ratio of the non-cross-linkable monomer (b) is 1% by mass or more, the handlability of the monomer composition is excellent. Furthermore, when the content ratio of the non-cross-linkable monomer (b) is 60% by mass or less, the cross-linking property or the curing property of the monomer composition is excellent and the solvent resistance of the light extraction film 10 is excellent.

The content ratio of the polymerization initiator (c) in the active energy ray curable monomer composition is preferably 0.1 to 10% by mass, more preferably 0.5 to 8% by mass, and even more preferably 1 to 5% by mass in the total amount of the monomer composition. When the content ratio of the polymerization initiator (c) is 0.1% by mass or more, the handlability or the curing property of the monomer composition is excellent. Furthermore, when the content ratio of the polymerization initiator (c) is 10% by mass or less, the light transmitting property of the light extraction film 10 is excellent.

The content ratio of the ultraviolet absorber in the active energy ray curable monomer composition is preferably 0.1 to 20% by mass, more preferably 0.3 to 15% by mass, and even more preferably 0.5 to 10% by mass in the total amount of the monomer composition. When the content ratio of the ultraviolet absorber is 0.1% by mass or more, it is possible to suppress the change in color of the light extraction film 10 due to ultraviolet ray exposure and thus the long-term stability is excellent. Furthermore, when the content ratio of the ultraviolet absorber is 20% by mass or less, the light transmitting property of the light extraction film 10 is excellent.

The content ratio of the photo-stabilizing agent in the active energy ray curable monomer composition is preferably 0.1 to 9% by mass, more preferably 0.3% to 7% by mass, and even more preferably 0.5 to 5% by mass in the total amount of the monomer composition. When the content ratio of the photo-stabilizing agent is 0.1% by mass or more, it is possible to suppress the change in color of the light extraction film 10 due to ultraviolet ray exposure and thus the long-term stability is excellent. Furthermore, when the content ratio of the photo-stabilizing agent is 9% by mass or less, the light transmitting property of the light extraction film 10 is excellent.

In the light extraction film of the invention, the refractive index of the light extraction film is preferably 1.55 to 1.65, from the viewpoint of having an excellent light transmitting property of the light extraction film 10 and excellent light extraction efficiency or luminance in the normal direction of the surface light-emitting body.

Incidentally, the refractive index is a value measured by using a sodium D line at 20°C.

In the light extraction film of the invention, a ratio (A1/A2) of a peak area (A1) derived from aromatic series to a peak area (A2) derived from other than the aromatic series when the light extraction film is measured by ¹³C-NMR is preferably 0.1 or more and even more preferably 0.3 to 3.0. When the peak area ratio A1/A2 is 0.1 or more, the content ratio of the monomer (x) unit is high and it is possible to achieve sufficient improvement in light extraction efficiency and luminance in the normal direction of the surface light-emitting body and sufficient suppression of emission angle dependence of the wavelength of light emitted from the surface light-emitting body.

Incidentally, the peak area (A1) derived from carbon of a portion, which exhibits aromaticity, of the light extraction film and the peak area (A2) derived from carbon of a portion other than the portion, which exhibits aromaticity, of the light extraction film can be obtained by using a solid ¹³C-NMR. In the solid ¹³C-NMR, peaks positioned in the range of carbon chemical shifts of 115 to 160 ppm are considered as peaks derived from carbon of a portion which exhibits aromaticity, and peaks positioned in the other range are considered as peaks derived from carbon of a portion other than the portion which exhibits aromaticity.

The light extraction film 10 is not particularly limited as long as it is possible to efficiently extract light from the EL element, but from the viewpoint of having excellent structure stability of the light extraction film 10 and excellent light extraction efficiency or luminance in the normal direction of the surface light-emitting body, it is preferable that the light extraction film 10 have the recessed and projected structure layer 11 and the base layer 12.

Regarding the light extraction film 10, from the viewpoint that it is possible to achieve sufficient improvement in light extraction efficiency and luminance in the normal direction of the surface light-emitting body and sufficient suppression of emission angle dependence of the wavelength of emitted light and it is also possible to improve long-term stability by suppressing a change in color of the light extraction film 10 due to ultraviolet ray exposure, it is preferable that the material constituting the light extraction film be formed by the monomer composition described above.

The recessed and projected structure layer 11 and the base layer 12 may have the same resin composition or different resin compositions, but from the viewpoint of having excellent productivity of the light extraction film 10, the same resin composition is preferable.

### (Recessed and Projected Structure Layer 11)

The recessed and projected structure layer 11 has the recessed and projected structure 13. According to this, the recessed and projected structure layer has a role of improving the light extraction efficiency and the luminance in the normal direction of the surface light-emitting body configured by combination with the EL element.

The recessed and projected structure 13 may be projections or depressions, but from the viewpoint of having excellent productivity of the light extraction film 10, projections are preferable.

Examples of the shape of the recessed and projected structure 13 include a spherical segment shape, a spherical segment trapezoidal shape, an ellipsoid spherical segment shape (a shape obtained by cutting a spheroid with one plane), an ellipsoid spherical segment trapezoidal shape (a shape obtained by cutting a spheroid with two planes that are parallel to each other), a pyramid shape, a pyramid trapezoidal shape, a conical shape, a conical trapezoidal shape, and roof-like shapes relating to these shapes (a shape in which a spherical segment shape, a spherical segment trapezoidal shape, an ellipsoid spherical segment shape, an ellipsoid spherical segment trapezoidal shape, a pyramid shape, a pyramid trapezoidal shape, a conical shape, or a conical trapezoidal shape extends along a bottom surface portion). These shapes of the recessed and projected structure 13 may be used alone or in combination of two or more kinds thereof. Among these shapes of the recessed and projected structure 13, from the viewpoint of having excellent light extraction efficiency or luminance in the normal direction of the surface light-emitting body, a spherical segment shape, a spherical segment trapezoidal shape, an ellipsoid spherical segment shape, an ellipsoid spherical segment trapezoidal shape, a pyramid shape, and a pyramid trapezoidal shape are preferable, a spherical segment shape, an ellipsoid spherical segment shape, and a pyramid shape are more preferable, a spherical segment shape and an ellipsoid spherical segment shape are even more preferable, and a spherical segment shape is further preferable.

An arrangement example of the recessed and projected structure 13 is illustrated in Fig. 2.

Examples of the arrangement of the recessed and projected structure 13 include hexagonal alignment (Fig. 2(a)), rectangular alignment (Fig. 2(b)), diamond alignment (Fig. 2(c)), linear alignment (Fig. 2(d)), circular alignment (Fig. 2(e)), and random alignment (Fig. 2(f)). Among these examples of arrangement of the recessed and projected structure 13, from the viewpoint of having excellent light extraction efficiency or luminance in the normal direction of the surface light-emitting body, hexagonal alignment, rectangular alignment, and diamond alignment are preferable, and hexagonal alignment and rectangular alignment are more preferable.

An example of the recessed and projected structure 13 is illustrated in Fig. 3.

In the present specification, a bottom surface portion 15 of the recessed and projected structure 13 is a virtual planar portion surrounded by an outer peripheral edge of a bottom portion (in the case of having the base layer 12, a contact surface that comes in contact with the base layer 12) of the recessed and projected structure 13.

Furthermore, in the present specification, a maximum diameter L of the bottom surface portion 15 of the recessed and projected structure 13 indicates a length of the longest part of the bottom surface portion 15 of the recessed and projected structure 13, and an average maximum diameter Lₐᵥₑ of the bottom surface portion 15 of the recessed and projected structure 13 is obtained by photographing the surface, which has the recessed and projected structure 13, of the light extraction film 10 by a scanning microscope, measuring the maximum diameter L of the bottom surface portion 15 of the recessed and projected structure 13 at five positions, and averaging the values thus measured.

Further, in the present specification, in the case of the projection structure, a height H of the recessed and projected structure 13 indicates a height from the bottom surface portion 15 of the recessed and projected structure 13 to the highest part of the recessed and projected structure 13, and in the case of the depression structure, the height H indicates a height from the bottom surface portion 15 of the recessed and projected structure 13 to the lowest part of the recessed and projected structure 13. An average height Have of the recessed and projected structure 13 is obtained by photographing the cross section of the light extraction 10 by a scanning microscope, measuring the height H of the recessed and projected structure 13 at five positions, and averaging the values thus measured.

The average maximum diameter Lₐᵥₑ of the bottom surface portion 15 of the recessed and projected structure 13 is preferably 0.5 to 150 µm, more preferably 1 to 130 µm, and even more preferably 2 to 100 µm, from the viewpoint of further improving the light extraction efficiency or the luminance in the normal direction of the surface light-emitting body.

The average height Hₐᵥₑ of the recessed and projected structure 13 is preferably 0.25 to 75 µm, more preferably 0.5 to 65 µm, and even more preferably 1 to 50 µm, from the viewpoint of further improving the light extraction efficiency or the luminance in the normal direction of the surface light-emitting body.

An aspect ratio of the recessed and projected structure 13 is preferably 0.3 to 1.4, more preferably 0.35 to 1.3, and even more preferably 0.4 to 1.0, from the viewpoint of further improving the light extraction efficiency or the luminance in the normal direction of the surface light-emitting body.

Incidentally, the aspect ratio of the recessed and projected structure 13 is calculated from the average height Have of the recessed and projected structure 13/the average maximum diameter Lₐᵥₑ of the bottom surface portion 15 of the recessed and projected structure 13.

Examples of the shape of the bottom surface portion 15 of the recessed and projected structure 13 include polygonal shapes such as a triangular shape and a quadrilateral shape; circular shapes such as a perfect circular shape and an elliptical shape; and amorphous shapes. These shapes of the bottom surface portion 15 of the recessed and projected structure 13 may be used alone or in combination of two or more kinds thereof. Among these shapes of the bottom surface portion 15 of the recessed and projected structure 13, from the viewpoint of further improving the light extraction efficiency or the luminance in the normal direction of the surface light-emitting body, polygonal shapes and circular shapes are preferable, and circular shapes are more preferable.

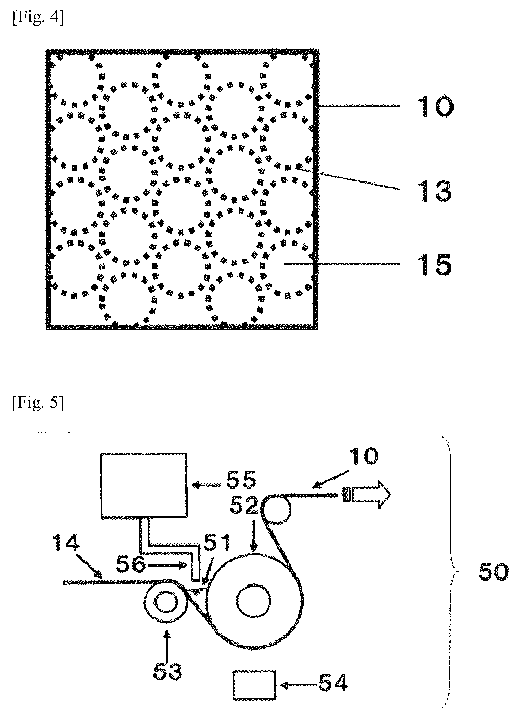

An example of the light extraction film viewed from the upper side thereof is illustrated in Fig. 4.

A ratio of an area of the bottom surface portion 15 of the recessed and projected structure 13 (an area surrounded by a dotted line in Fig. 4) to an area of the light extraction film 10 (an area surrounded by a solid line in Fig. 4) is preferably 20 to 99%, more preferably 25 to 95%, even more preferably 30 to 93%, and further preferably 70 to 90%, from the viewpoint of further improving the light extraction efficiency or the luminance in the normal direction of the surface light-emitting body. In the present specification, the ratio of the area of the bottom surface portion 15 of the recessed and projected structure 13 to the area of the light extraction film 10 is referred to as the "occupancy of the recessed and projected structure."

Incidentally, in a case where the bottom surface portions 15 of the recessed and projected structures 13 are all circular shapes of the same size, the maximum value of the ratio of the area of the bottom surface portion 15 of the recessed and projected structure 13 to the area of the light extraction film 10 is about 91%.

### (Base Layer 12)

It is preferable that the base layer 12 be provided from the viewpoint that the base layer supports the recessed and projected structure 13 of the recessed and projected structure layer 11. The base layer 12 has a role of maintaining the shape of the recessed and projected structure 13 by alleviating the stress accompanied with polymerization shrinking or the like during curing of the monomer composition.

The thickness of the base layer 12 is preferably 3 to 60 µm, more preferably 5 to 50 µm, and even more preferably 10 to 40 µm, from the viewpoint of having excellent flexibility of the light extraction film 10 and excellent adhesiveness between the base layer and the base material 14 which will be described later. When the thickness of the base layer 12 is 3 µm or more, the suppression of the emission angle dependence of the wavelength of light emitted from the surface light-emitting body is further improved. Furthermore, when the thickness of the base layer 12 is 60 µm or less, the light extraction efficiency or the luminance in the normal direction of the surface light-emitting body is further improved.

### (Base Material 14)

The light extraction film of the invention configures the surface light-emitting body by combination with the EL element as described later. However, here, in order to maintain the shape of the light extraction film 10, the base material 14 may be provided on a surface of the light extraction film 10 on which the recessed and projected structure 13 is not formed, that is, between the light extraction film 10 and the EL element.

When the light extraction film 10 includes the base layer 12, the base material 14 is provided on a surface (the lower surface in Fig. 1) opposite to the surface (the upper surface in Fig. 1) of the base layer 12 on which the recessed and projected structure layer 11 is provided.

As described later, at the time of producing the recessed and projected structure layer 11 and the base layer 12, an active energy ray can be irradiated onto an active energy ray curable monomer composition via the base material 14. In this regard, from the viewpoint of having an excellent curing property of an active energy ray curable monomer composition, a base material allowing transmission of the active energy ray is preferable as the base material 14.

Furthermore, the refractive index of the base material 14 is preferably 1.55 to 1.65.

Examples of a material of the base material 14 include acrylic resins; polycarbonate resins; polyester resins such as polyethylene terephthalate, polybutylene terephthalate, and polyethylene naphthalate; styrene resins such as polystyrene and an ABS resin; vinyl chloride resins; cellulose resins such as diacetyl cellulose and triacetyl cellulose; imide resins such as polyimide and polyimideamide; glass; and metals. Among these materials of the base material 14, from the viewpoint of having excellent flexibility and an excellent light transmitting property for an active energy ray, acrylic resins, polycarbonate resins, polyester resins, styrene resins, cellulose resins, and imide resins are preferable, acrylic resins, polycarbonate resins, polyester resins, and imide resins are more preferable, and polyester resins are even more preferable.

The thickness of the base material 14 is preferably 10 to 1000 µm, more preferably 20 to 500 µm, and even more preferably 25 to 300 µm, from the viewpoint of having excellent handlability of the light extraction film 10 and an excellent curing property of an active energy ray curable monomer composition.

In order to improve the adhesiveness between the base material 14 and the light extraction film 10, adhesion facilitating treatment may be performed on the surface of the base material 14 as necessary.

Examples of a method for the adhesion facilitating treatment include a method of forming an easy adhesion layer consisting of a polyester resin, an acrylic resin, a urethane resin, or the like on the surface of the base material 14 and a method of roughening the surface of the base material 14.

In addition to the adhesion facilitating treatment, surface treatment of the base material 14 such as anti-static, anti-reflection, or anti-adhesion between base materials may be performed as necessary.

In the light extraction film of the invention, from the viewpoint of easy attachment to the EL element and excellent handlability of the light extraction film, for example, as illustrated in Fig. 1, an adhesive layer 21 and a protective film 22 may be sequentially laminated on a surface (the lower surface) opposite to the surface of the base material 14 on which the light extraction film 10 is formed.

### (Adhesive Layer 21)

The adhesive layer 21 for adhering to an EL element 30 may be provided on the surface at the light incident surface side of the light extraction film of the invention as illustrated in Fig. 1. When the base material 14 is attached to the light extraction film 10, the adhesive layer 21 may be provided on the surface of the base material 14 as illustrated in Fig. 1.

As the adhesive layer 21, for example, a known adhesive or the like is exemplified.

Furthermore, the refractive index of the adhesive layer 21 is preferably 1.48 to 1.58.

### (Protective Film 22)

In order to enhance the handlability of the light extraction film 10, the protective film 22 may be provided on the surface of the adhesive layer 21 as illustrated in Fig. 1. When the light extraction film 10 or the like is attached to the surface of the EL element 30, the protective film 22 may be removed from the light extraction film 10 or the like.

As the protective film 22, for example, a known protective film or the like is exemplified.

### (Method for Producing Light Extraction Film 10)

The method for producing a light extraction film of the invention is a method for producing a light extraction film which is laminated on a substrate of an EL element, and is characterized by including supplying a monomer composition containing a monomer (x) having at least one skeleton of a fluorene skeleton, a biphenyl skeleton, and a naphthalene skeleton to a space between a base material and a mold having a transferring portion of a recessed and projected structure, and curing the monomer composition. The content of the monomer (x) in the monomer composition is preferably 30% by mass or more and even more preferably 30 to 86% by mass. Incidentally, the polymerization of the monomer (x) and a monomer, which may be contained as necessary, other than the monomer (x) occurs so that the resin (X) can be synthesized.

As the method for producing the light extraction film 10, for example, a method of using an apparatus 50 as illustrated in Fig. 5 or the like is exemplified.

Hereinafter, the method for producing the light extraction film 10 by using the apparatus 50 illustrated in Fig. 5 will be described, but is not limited to the method of using the apparatus 50 illustrated in Fig. 5.

A monomer composition 51 for forming a material constituting the light extraction film 10 is prepared by a general method, and the monomer composition 51 is put into a storage tank 55 in advance. Incidentally, the monomer composition 51 described herein is an active energy ray curable monomer composition.

The base material 14 is introduced between a cylindrical roll mold 52 having a transferring portion of a recessed and projected structure and a nip roll 53 made of rubber. In this state, the monomer composition 51 is supplied to a space between the rotating roll mold 52 and the base material 14 from the tank 55 through a pipe 56 which has a nozzle attached to a tip end thereof.

The monomer composition 51 interposed between the rotating roll mold 52 and the base material 14 is cured by an active energy ray in the vicinity of an active energy ray irradiation apparatus 54. The obtained cured product is released from the roll mold 52 to thereby obtain the light extraction film 10 attached with the base material 14.

The viscosity of the monomer composition 51 is preferably 10 to 3000 mPa·s, more preferably 20 to 2500 mPa·s, and even more preferably 30 to 2000 mPa·s, from the viewpoint of having excellent handlability at the time of producing the light extraction film 10.

Examples of the roll mold 52 include a metal mold of aluminum, yellow copper, steel, or the like; a resin mold of a silicone resin, a urethane resin, an epoxy resin, an ABS resin, a fluororesin, a polymethylpentene resin, or the like; a plated resin mold; and a mold produced with a material in which various metal powders are mixed with a resin. Among these roll molds 52, from the viewpoint of having excellent heat resistance or mechanical strength and suitability for continuous production, a metal mold is preferable. Specifically, the metal mold is preferred in many aspects that it is resistant to heat generated by polymerization, hardly deformed, and resistant to scratches and it allows temperature control and is suitable for fine molding or the like.

On the roll mold 52, it is necessary to form a transfer surface having projections or depressions for forming the recessed and projected structure 13 of the light extraction film 10, that is, a transferring portion of the recessed and projected structure.

Examples of a method for producing a transfer surface include cutting by a diamond bite and etching as described in WO 2008/069324 A. Among these methods for producing a transfer surface, from the viewpoint of easily forming projections or depressions having a curved surface, etching as described in WO 2008/069324 A is preferable.

Furthermore, as a method for producing a transfer surface, it is possible to use a method of producing the roll mold 52 of a cylindrical form by winding a metal thin film, which is produced from a master mold having depressions or projections with reversed projections or depressions of the transfer surface by using electroforming, on a roll core member.

A heat source facility such as a sheath heater or a hot water jacket may be installed on the inside or the outside of the roll mold 52, as necessary, in order to maintain the surface temperature.

Examples of the active energy ray generated from the active energy ray irradiation apparatus 54 include ultraviolet rays, electron beams, X rays, infrared rays, and visible rays. Among these active energy rays, from the viewpoint of having an excellent curing property of an active energy ray curable monomer composition and the viewpoint that the deterioration of the light extraction film 10 can be suppressed, ultraviolet rays and electron beams are preferable, and ultraviolet rays are more preferable.

Examples of a source for emitting the active energy ray of the active energy ray irradiation apparatus 54 include a chemical lamp, a low pressure mercury lamp, a high pressure mercury lamp, a metal halide lamp, an electrodeless ultraviolet lamp, a visible light halogen lamp, and a xenon lamp.

The accumulated light quantity of the active energy ray of the active energy ray irradiation apparatus 54 is not particularly limited, but from the viewpoint of having an excellent curing property of an active energy ray curable composition and suppressing the deterioration of the light extraction film 10, the accumulated light quantity is preferably 0.01 to 10 J/cm² and more preferably 0.5 to 8 J/cm².

A heat source facility such as a sheath heater or a hot water jacket may be installed on the inside or the outside of the tank 55, as necessary, in order to maintain the storage temperature of the monomer composition 51.

### (Surface Light-Emitting Body)

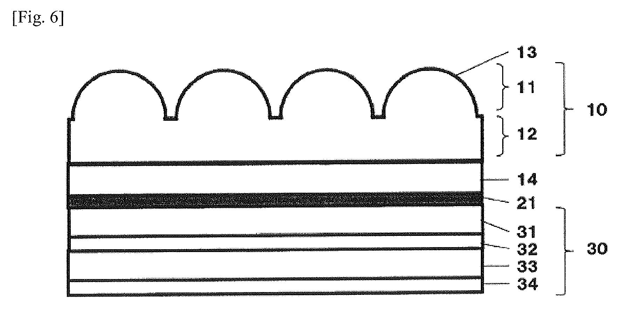

The surface light-emitting body of the invention is characterized by including the light extraction film of the invention and an EL element, and preferably has a base material (preferably a polyester resin base material) or an adhesive layer between the light extraction film and the EL element. As the surface light-emitting body of the invention, for example, a surface light-emitting body as illustrated in Fig. 6 is exemplified.

Hereinafter, the surface light-emitting body of Fig. 6 will be described, but the surface light-emitting body of the invention is not limited to the surface light-emitting body of Fig. 6.

The surface light-emitting body illustrated in Fig. 6 is provided with the light extraction film 10 on the surface of a glass substrate 31 of the EL element 30, which is formed by sequentially laminating the glass substrate 31, a positive electrode 32, a light emitting layer 33, and a negative electrode 34 thereon, with the adhesive layer 21 and the base material 14 interposed therebetween. Incidentally, in the surface light-emitting body of the invention, the refractive index of the substrate of the EL element is preferably 1.45 to 1.55.

The surface light-emitting body in which the light extraction film 10 is provided on the EL element 30 is excellent in the light extraction efficiency or the luminance in the normal direction and can suppress the emission angle dependence of the wavelength of emitted light.

The amount of chromatic variation of the surface light-emitting body of the invention is preferably 0.03 or less, and even more preferably 0.01 or less. Furthermore, a smaller amount of chromatic variation of the surface light-emitting body is preferable, but the lower limit of the amount of chromatic variation in the surface light-emitting body of the invention is about 0.0001. Incidentally, the amount of chromatic variation is an amount of change in chromaticity of the xy color system which is measured by a luminance meter, but when the amount of chromatic variation is 0.01 or less, it is possible to sufficiently suppress the emission angle dependence of the wavelength of light emitted from the surface light-emitting body.

### EXAMPLES

Hereinafter, the invention will be described in detail by means of Examples, but the invention is not limited to these Examples.

Incidentally, "part" and "%" in Examples indicate "part by mass" and "% by mass."

### (Long-Term Stability Test)

The light extraction film obtained in each of Examples and Comparative Examples was subjected to an accelerated deterioration test by ultraviolet rays using an ultra-accelerated weather resistance tester (model name "METAL WEATHER," manufactured by DAYPLA WINTES CO., LTD.) under the conditions of an illuminance of 140 mW, a filter "KF-2," a temperature of 30°C, a humidity of 70 %RH, and a time period of 24 hours.

### (Measurement of Light Extraction Efficiency)

A 0.1 mm-thick light shielding sheet having a hole with a diameter of 10 mm was disposed on each of the surface light-emitting bodies obtained in Examples, Comparative Examples, and Reference Examples, and this was disposed on a sample aperture of an integrating sphere (manufactured by Labsphere, Inc., 6 inch in size). In this state, light emitted from the hole with a diameter of 10 mm of the light shielding sheet when the EL element was turned on by allowing a current of 10 mA to flow into the EL element was measured by a spectroscopic instrument (spectroscope: model name "PMA-12" (manufactured by Hamamatsu Photonics K.K.), software: software name "U6039-01 ver. 3.3.1 basic software for PMA") and corrected by a standard luminosity curve, and the number of photons of the surface light-emitting body was calculated.

When the number of photons of the surface light-emitting body obtained in Reference Example was considered as 100%, a ratio of the number of photons of the surface light-emitting body obtained in each of Example and Comparative Example was considered as the light extraction efficiency.

### (Measurement of Luminance in Normal Direction)

A 0.1 mm-thick light shielding sheet having a hole with a diameter of 10 mm was disposed on each of the surface light-emitting bodies obtained in Examples, Comparative Examples, and Reference Examples. In this state, light emitted from the hole with a diameter of 10 mm of the light shielding sheet when the EL element was turned on by allowing a current of 1.5 A to flow into the EL element was measured from the normal direction of the surface light-emitting body by a luminance meter (model name "BM-7," manufactured by TOPCON CORPORATION) to obtain a luminance value of the surface light-emitting body.

When the luminance value of the surface light-emitting body obtained in Reference Example was considered as 100%, a ratio of the luminance value of the surface light-emitting body obtained in each of Example and Comparative Example was considered as the luminance in the normal direction.

### (Measurement of Amount of Chromatic Variation)

A 0.1 mm-thick light shielding sheet having a hole with a diameter of 10 mm was disposed on each of the surface light-emitting bodies obtained in Examples, Comparative Examples, and Reference Examples. In this state, light emitted from the hole with a diameter of 10 mm of the light shielding sheet when the EL element was turned on by allowing a current of 1.5 A to flow into the EL element was measured for chromaticities u' and v' in xy color system by a luminance meter (model name "BM-7," manufactured by TOPCON CORPORATION) from the normal direction (0°) of the surface light-emitting body, from the direction tilted at 10° from the normal direction of the surface light-emitting body, from the direction tilted at 20° from the normal direction of the surface light-emitting body, from the direction tilted at 30° from the normal direction of the surface light-emitting body, from the direction tilted at 40° from the normal direction of the surface light-emitting body, from the direction tilted at 50° from the normal direction of the surface light-emitting body, from the direction tilted at 60° from the normal direction of the surface light-emitting body, from the direction tilted at 70° from the normal direction of the surface light-emitting body, from the direction tilted at 75° from the normal direction of the surface light-emitting body, and from the direction tilted at 80° from the normal direction of the surface light-emitting body, respectively. Values of u' at respective angles and an average value of u' were plotted on the horizontal axis and values v' at respective angles and an average value of v' were plotted on the vertical axis. Distances from the plotted points of the average values of u' and v' to the plotted points of the values of u' and v' at respective angles were calculated and a value at the longest distance was considered as the amount of chromatic variation.

Incidentally, a smaller amount of chromatic variation means better suppression of emission angle dependence of the wavelength of light emitted from the surface light-emitting body.

### (Peak Area Ratio of ¹³C-NMR)

The peak area ratio of ¹³C-NMR of the light extraction film was measured by a solid ¹³C-NMR. First, the resin (X) was cut into little pieces and the pieces were put into a sample tube having an inner diameter of 2.5 mm. Subsequently, measurement was carried out by a DD-MAS method under the conditions of 90°, a pulse width of 3 µs, a sample rotation frequency of 16 kHz, a cumulated number of 4096, and a repeat waiting time of 60 seconds. In the obtained spectra, the peak area (A1) derived from aromatic series which is positioned in the range of carbon chemical shifts of 115 to 160 ppm and the peak area (A2) derived from other than the aromatic series which is positioned in other ranges were obtained, and then the peak area ratio (A1/A2) was calculated.

### [Production Example 1]

### (Production of Active Energy Ray Curable Monomer Composition A)

50 parts of fluorene diacrylate represented by the following Formula (6), 50 parts of acrylate represented by the following Formula (7) (trade name "NK Ester A-LEN-10," manufactured by Shin Nakamura Chemical Co., Ltd.), and 1.6 parts of 1-hydroxycyclohexyl phenyl ketone (trade name "IRGACURE 184," manufactured by BASF) were mixed with one another to obtain an active energy ray curable monomer composition A.

Incidentally, the refractive index of the cured product of the monomer composition A was 1.61.

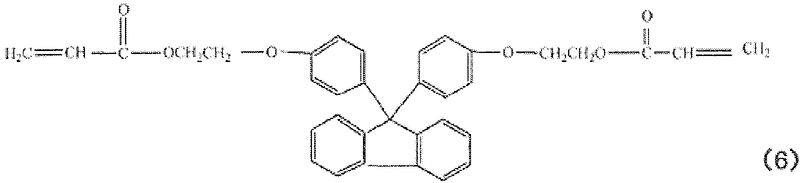

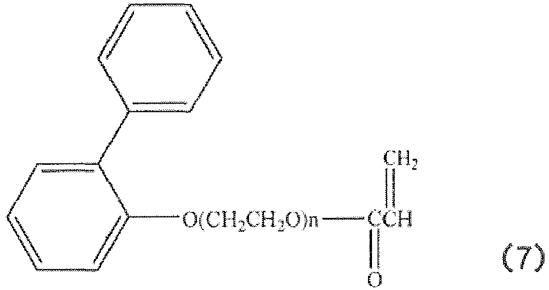

### [Production Example 2]

### (Production of Active Energy Ray Curable Monomer Composition B)

50 parts of fluorene diacrylate represented by the above Formula (6), 20 parts of dimethacrylate represented by the following Formula (8) (trade name "Acryester PBOM 2000," manufactured by MITSUBISHI RAYON CO., LTD.), 20 parts of diacrylate represented by the following Formula (9) (trade name "ABE-300," manufactured by Shin Nakamura Chemical Co., Ltd.), 10 parts of acrylate represented by the following Formula (10) (trade name "New Frontier PHE," manufactured by DKS Co. Ltd.), and 1.6 parts of 1-hydroxycyclohexyl phenyl ketone (trade name "IRGACURE 184," manufactured by BASF) were mixed with one another to obtain an active energy ray curable resin monomer composition B.

Incidentally, the refractive index of the cured product of the monomer composition B was 1.59.

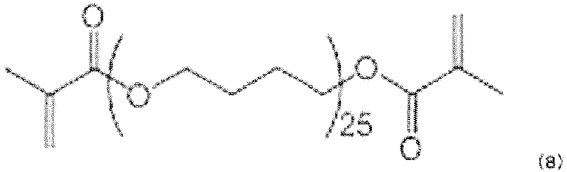

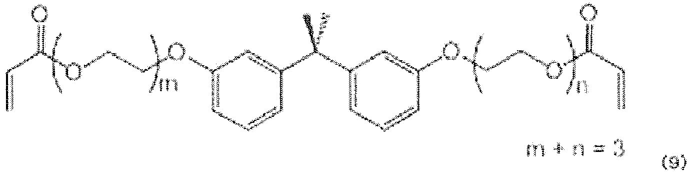

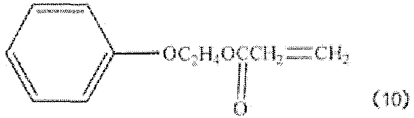

### [Production Example 3]

### (Production of Active Energy Ray Curable Monomer Composition C)

40 parts of fluorene diacrylate represented by the above Formula (6), 40 parts of acrylate represented by the above Formula (7), 20 parts of dimethacrylate represented by the above Formula (8), and 1.6 parts of 1-hydroxycyclohexyl phenyl ketone (trade name "IRGACURE 184," manufactured by BASF) were mixed with one another to obtain an active energy ray curable monomer composition C.

Incidentally, the refractive index of the cured product of the monomer composition C was 1.58.

### [Production Example 4]

### (Production of Active Energy Ray Curable Monomer Composition D)

70 parts of fluorene diacrylate represented by the above Formula (6), 30 parts of acrylate represented by the above Formula (10), and 1.6 parts of 1-hydroxycyclohexyl phenyl ketone (trade name "IRGACURE 184," manufactured by BASF) were mixed with one another to obtain an active energy ray curable monomer composition D.

Incidentally, the refractive index of the cured product of the monomer composition D was 1.59.

### [Production Example 5]

### (Production of Active Energy Ray Curable Monomer Composition E)

70 parts of fluorene diacrylate represented by the above Formula (6), 30 parts of dimethacrylate represented by the above Formula (8), and 1.6 parts of 1-hydroxycyclohexyl phenyl ketone (trade name "IRGACURE 184," manufactured by BASF) were mixed with one another to obtain an active energy ray curable monomer composition E.

Incidentally, the refractive index of the cured product of the monomer composition E was 1.58.

### [Production Example 6]

### (Production of Active Energy Ray Curable Monomer Composition F)

36 parts of fluorene diacrylate represented by the above Formula (6), 36 parts of acrylate represented by the above Formula (7), 18 parts of dimethacrylate represented by the above Formula (8), 10 parts of silicone resin spherical fine particles (trade name "TSR9000," manufactured by Momentive Performance Materials Inc., refractive index: 1.42, volume average particle diameter: 2 µm), and 1.6 parts of 1-hydroxycyclohexyl phenyl ketone (trade name "IRGACURE 184," manufactured by BASF) were mixed with one another to obtain an active energy ray curable monomer composition F.

Incidentally, the refractive index of the cured product of the monomer composition F was 1.58.

### [Production Example 7]

### (Production of Active Energy Ray Curable Monomer Composition G)

32 parts of fluorene diacrylate represented by the above Formula (6), 32 parts of acrylate represented by the above Formula (7), 16 parts of dimethacrylate represented by the above Formula (8), 20 parts of silicone resin spherical fine particles (trade name "TSR9000," manufactured by Momentive Performance Materials Inc., refractive index: 1.42, volume average particle diameter: 2 (µm), and 1.6 parts of 1-hydroxycyclohexyl phenyl ketone (trade name "IRGACURE 184," manufactured by BASF) were mixed with one another to obtain an active energy ray curable monomer composition G.

Incidentally, the refractive index of the cured product of the monomer composition G was 1.58.

### [Production Example 8]

### (Production of Active Energy Ray Curable Monomer Composition H)

10 parts of fluorene diacrylate represented by the above Formula (6), 60 parts of acrylate represented by the above Formula (7), 30 parts of dimethacrylate represented by the above Formula (8), and 1.6 parts of 1-hydroxycyclohexyl phenyl ketone (trade name "IRGACURE 184," manufactured by BASF) were mixed with one another to obtain an active energy ray curable monomer composition H.

Incidentally, the refractive index of the cured product of the monomer composition H was 1.51.

### [Production Example 9]

### (Production of Active Energy Ray Curable Monomer Composition 1)

100 parts of urethane acrylate represented by the following Formula (11) (trade name "M-315," manufactured by Nippon Kayaku Co., Ltd.) and 1.6 parts of 1-hydroxycyclohexyl phenyl ketone (trade name "IRGACURE 184," manufactured by BASF) were mixed with each other to obtain an active energy ray curable monomer composition I.

Incidentally, the refractive index of the cured product of the monomer composition I was 1.50.

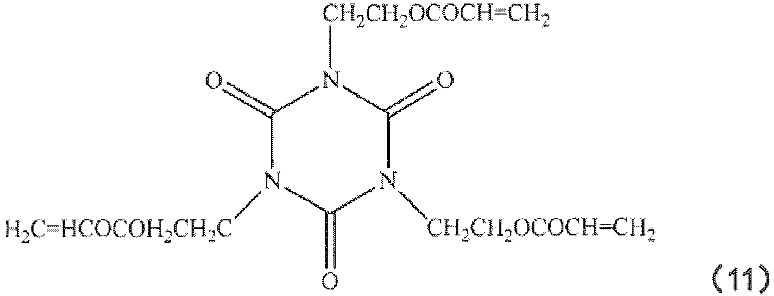

### [Production Example 10]

### (Production of Roll Mold Provided with Spherical Segment Shaped Transferring Portion)

On an outer peripheral surface of a steel roll with an outer diameter of 200 mm and an axial direction length of 320 mm, copper plating with a thickness of 200 µm and a Vickers hardness of 230 Hv was performed. The surface of the copper plating layer was coated with a sensitizer, and was subjected to laser light exposure, development, and etching, thereby obtaining a mold having a transferring portion formed therein, in which hemispherical depressions having a diameter of 50 µm and a depth of 25 µm are arranged on the copper plating layer in a hexagonal alignment manner at the minimum interval of 3 µm. On the surface of the obtained mold, chrome plating was performed to give an anti-corrosion property and durability, and thus a roll mold was obtained.

### [Production Example 11]

### (Production of Roll Mold Provided with Ellipsoid-Spherical Segment Shaped Transferring Portion)

On an outer peripheral surface of a steel roll with an outer diameter of 200 mm and an axial direction length of 320 mm, copper plating with a thickness of 200 µm and a Vickers hardness of 230 Hv was performed. The copper-plated steel roll was cut into the copper plating layer while an elliptically-contoured ball end mill blade was rotated by an air spindle, thereby obtaining a mold having a transferring portion formed therein, in which hemispherical depressions having a diameter of 30 µm and a depth of 18 µm are arranged on the copper plating layer in a hexagonal alignment manner at the minimum interval of 1 µm. On the surface of the obtained mold, chrome plating was performed to give an anti-corrosion property and durability, and thus a roll mold was obtained.

Furthermore, a mold having a transferring portion formed therein, in which hemispherical depressions having a diameter of 30 µm and a depth of 18 µm are arranged on the copper plating layer in a hexagonal alignment manner at the minimum interval of 2 µm, was obtained in the same manner as described above.

### [Production Example 12]

### (Production of Roll Mold Provided with Pyramid Shaped Transferring Portion)

On an outer peripheral surface of a steel roll with an outer diameter of 200 mm and an axial direction length of 320 mm, copper plating with a thickness of 200 µm and a Vickers hardness of 230 Hv was performed. The copper-plated steel roll was cut into the copper plating layer by using a single-crystal diamond tool having a point angle of 90°, thereby obtaining a mold having a transferring portion formed therein (occupancy 100%), in which quadrangular pyramidal depressions having one side length side of 50 µm and a depth of 25 µm are arranged on the copper plating layer without a gap. On the surface of the obtained mold, chrome plating was performed to give an anti-corrosion property and durability, and thus a roll mold was obtained.

### [Reference Example 1]

An EL element A in which the light extraction film on the surface of the light emitting surface side of Symfos OLED-010K (manufactured by KONICA MINOLTA, INC., white OLED element) is removed was used as a surface light-emitting body without any change.

Incidentally, the refractive index of the glass substrate of the EL element A is 1.50.

### [Example 1]

On the roll mold obtained in Production Example 10, the active energy ray curable monomer composition A was coated, a polyethylene terephthalate base material (trade name "DIAFOIL T910E125," manufactured by Mitsubishi Plastics, Inc., refractive index: 1.60) with a thickness of 125 µm was disposed thereon, and then the active energy ray curable monomer composition A was evenly stretched using a nip roll such that the thickness of the base layer became 20 µm. Thereafter, ultraviolet rays were irradiated from the top of the base material to cure the active energy ray curable monomer composition A interposed between the roll mold and the base material. The assembly of the obtained cured product and the base material was released from the roll mold to thereby obtain a light extraction film attached with the base material.

The refractive index of the cured active energy ray curable monomer composition A was 1.61 as described in the section "Refractive index" in Table 1.

Regarding the size of the recessed and projected structure of the light extraction film calculated from an image obtained by photographing the obtained light extraction film by a scanning microscope, the average maximum diameter Lₐᵥₑ was 48.2 µm and the average height Hₐᵥₑ was 26.0 µm, and a recessed and projected structure consisting of spherical segment shaped projections roughly corresponding to the size of the depressions of the roll mold was obtained. Furthermore, from the image obtained by photographing the obtained light extraction film by a scanning microscope, the recessed and projected structure of the obtained light extraction film corresponded to the roll mold and was arranged in a hexagonal alignment manner at the minimum interval of 3 µm. The ratio of total area of the bottom surface portion of the recessed and projected structure to the area of the light extraction film (the occupancy of the recessed and projected structure) was 76%.

On the light emitting surface side of the EL element A, Cargille standard refractive index liquid (refractive index of 1.52, manufactured by MORITEX Corporation) was coated as an adhesive layer. The surface of the base material attached to the light extraction film was subjected to optical adhesion with respect to this adhesive layer to thereby obtain a surface light-emitting body. The measurement results of the light extraction efficiency, the luminance in the normal direction, and the amount of chromatic variation of the obtained surface light-emitting body are shown in Table 1 together with the refractive index of the cured active energy ray curable monomer composition.

### [Examples 2 to 12 and Comparative Example 1]

A surface light-emitting body was obtained by performing the same operation as in Example 1, except that the active energy ray curable monomer composition to be used at the time of producing the light extraction film was changed to a composition described in the section "Composition" in Table 1 and the transferring portion of the roll mold was changed to a transferring portion described in the section "Shape of recessed and projected structure" in Table 1. Incidentally, in Example 9, a mold provided with a transferring portion in which the minimum interval of hemispherical depressions is 1 µm was used, and in Example 10, a mold provided with a transferring portion in which the minimum interval of hemispherical depressions is 2 µm was used. The measurement results of the light extraction efficiency, the luminance in the normal direction, and the amount of chromatic variation of the obtained surface light-emitting body are shown in Table 1 together with the refractive index of the cured active energy ray curable monomer composition.

### [Comparative Example 2]

On a polyethylene terephthalate base material (trade name "DIAFOIL T910E125," manufactured by Mitsubishi Plastics, Inc., refractive index: 1.60) with a thickness of 125 µm, the active energy ray curable monomer composition C was coated, a polyethylene terephthalate base material (trade name "DIAFOIL T910E125," manufactured by Mitsubishi Plastics, Inc., refractive index: 1.60) with a thickness of 125 µm was disposed thereon, and then the active energy ray curable monomer composition C was evenly stretched using a nip roll such that the thickness of the base layer became 20 µm. Thereafter, ultraviolet rays were irradiated from the top of the base material to cure the active energy ray curable monomer composition C interposed between the base materials, and one base material was removed from the obtained cured product to thereby obtain a light extraction film attached with the other base material.

Next, on the light emitting surface side of the EL element A, Cargille standard refractive index liquid (refractive index of 1.52, manufactured by MORITEX Corporation) was coated as an adhesive layer. The surface of the base material attached to the light extraction film was subjected to optical adhesion with respect to this adhesive layer to thereby obtain a surface light-emitting body. The measurement results of the light extraction efficiency, the luminance in the normal direction, and the amount of chromatic variation of the obtained surface light-emitting body are shown in Table 1 together with the refractive index of the cured active energy ray curable monomer composition.

**[Table 1]**

| | Light extraction film | | | | | Evaluation result of surface light-emitting body | | |
|---|---|---|---|---|---|---|---|---|
| | Composition | Shape of recessed and projected structure | Refractive index of cured product | Occupancy of recessed and projected structure (%) | ¹³C-NMR peak area ratio (A1/A2) | Light extraction efficiency (%) | Luminance in normal direction (%) | Amount of chromatic variation |
| Reference Example 1 | - | - | - | - | - | 100 | 100 | 0,0124 |
| Example 1 | A | Spherical segment | 1,61 | 76 | 1.31 | 178,6 | 164,2 | 0.0070 |
| Example 2 | B | Spherical segment | 1,59 | 76 | 0,99 | 178.0 | 166,1 | 0,0068 |
| Example 3 | C | Spherical segment | 1,58 | 76 | 0,18 | 178,8 | 160,5 | 0.0060 |
| Example 4 | D | Spherical segment | 1,59 | 76 | 1,44 | 180,8 | 163,2 | 0,0068 |
| Example 5 | E | Spherical segment | 1,58 | 76 | 0,15 | 183,3 | 169,3 | 0.0010 |
| Example 6 | F | Spherical segment | 1,58 | 76 | 0,18 | 182,9 | 167,1 | 0,0012 |
| Example 7 | G | Spherical segment | 1,58 | 76 | 0,18 | 182,1 | 168.0 | 0.0010 |
| Example 8 | H | Spherical segment | 1,51 | 76 | 0,18 | 179,8 | 160,8 | 0,0071 |
| Example 9 | C | Ellipsoid spherical segment | 1,58 | 90 | 0,18 | 181,2 | 185,3 | 0.0090 |
| Example 10 | C | Ellipsoid spherical segment | 1,58 | 84 | 0,18 | 180,8 | 165.0 | 0.0080 |
| Example 11 | C | Pyramid | 1,58 | 100 | 0,18 | 180,6 | 192,3 | 0.0130 |
| Example 12 | C | Pyramid | 1,58 | 100 | 0,18 | 177,5 | 176,8 | 0.0210 |
| Comparative Example 1 | I | Spherical segment | 1.50 | 76 | 0 | 175,5 | 155.0 | 0.0080 |
| Comparative Example 2 | C | None | 1,58 | - | 0,18 | 101,8 | 100,1 | 0,0143 |

The surface light-emitting body obtained in each of Examples 1 to 12 which includes the light extraction film of the invention was excellent in the light extraction efficiency and the luminance in the normal direction and was excellent in suppression of the emission angle dependence of the wavelength of emitted light.

On the other hand, regarding the surface light-emitting body obtained in Comparative Example 1 which used the light extraction film produced by using the monomer composition containing no monomer (x), the light extraction efficiency and the luminance in the normal direction were not sufficiently improved.

Incidentally, regarding the surface light-emitting body obtained in Comparative Example 2, since the surface of the light extraction film does not have the recessed and projected structure, the light extraction efficiency and the luminance in the normal direction were not sufficiently improved.

### [Example 13]

### (Production of Active Energy Ray Curable Monomer Composition J)

40 parts of fluorene diacrylate represented by the following Formula (12) (trade name "EA-0100," manufactured by Osaka Gas Chemicals Co., Ltd.), 10 parts of dimethacrylate represented by the following Formula (8) (trade name "Acryester PBOM 2000," manufactured by MITSUBISHI RAYON CO., LTD.), 20 parts of dimethacrylate represented by the following Formula (9) (trade name "ABE-300," manufactured by Shin Nakamura Chemical Co., Ltd.), 30 parts of acrylate represented by the following Formula (13) (trade name "New Frontier PHE," manufactured by DKS Co. Ltd.), and 1 part of polymerization initiator (trade name "Lucirin TPO," manufactured by BASF) were mixed with one another to obtain a preliminary monomer composition.

Incidentally, the refractive index of the cured product of the obtained preliminary monomer composition is 1.58 and the ratio (A1/A2) of the peak area (A1) derived from aromatic series to the peak area (A2) derived from other than the aromatic series as measured by ¹³C-NMR is 0.70.

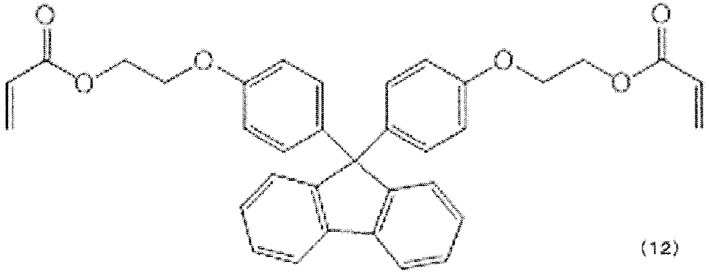

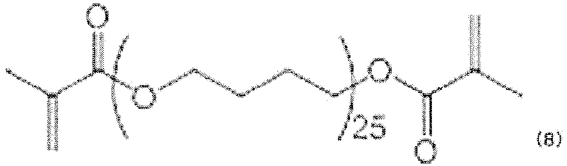

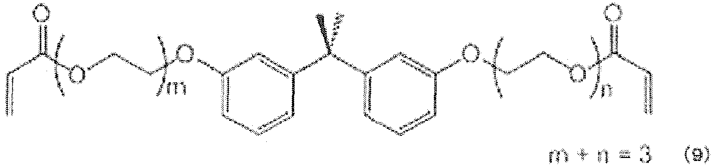

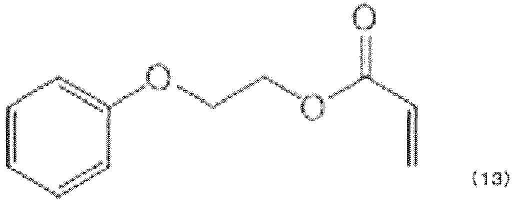

95% of the obtained preliminary monomer composition and 5% of hydroxyphenyltriazine-based compound (trade name "Tinuvin 479," manufactured by BASF) as an ultraviolet absorber were mixed with each other to obtain an active energy ray curable monomer composition J.

### (Production of Roll Mold)

On an outer peripheral surface of a steel roll with an outer diameter of 200 mm and an axial direction length of 320 mm, copper plating with a thickness of 200 µm and a Vickers hardness of 230 Hv was performed. The surface of the copper plating layer was coated with a sensitizer, and was subjected to laser light exposure, development, and etching, thereby obtaining a mold having a transferring portion formed therein, in which hemispherical depressions having a diameter of 50 µm and a depth of 25 µm are arranged on the copper plating layer in a hexagonal alignment manner at the minimum interval of 5 µm. On the surface of the obtained mold, chrome plating was performed to give an anti-corrosion property and durability, and thus a roll mold was obtained.

### (Production of Light Extraction Film)

On the obtained roll mold, the obtained active energy ray curable monomer composition J was coated, a polyethylene terephthalate base material (trade name "DIAFOIL T910E125," manufactured by Mitsubishi Plastics, Inc., refractive index: 1.60) with a thickness of 125 µm was disposed thereon, and then the active energy ray curable monomer composition J was evenly stretched using a nip roll. Thereafter, ultraviolet rays were irradiated from the top of the base material to cure the active energy ray curable monomer composition J interposed between the roll mold and the base material, and the cured product of the monomer composition J was released from the roll mold to thereby obtain a light extraction film attached with the base material. By controlling the pressing pressure of the roll mold at the time of curing, it was possible to control the thickness of the base layer, and in Example 13, the thickness of the base layer was set to 30 µm.

Regarding the size of the recessed and projected structure of the light extraction film calculated from an image obtained by photographing the obtained light extraction film by a scanning microscope, the average maximum diameter Lₐᵥₑ was 48.0 µm and the average height Have was 27.1 µm, and spherical segment shaped projections roughly corresponding to the size of the depressions of the roll mold were obtained. Furthermore, from the image photographed by a scanning microscope, the recessed and projected structure of the obtained light extraction film corresponded to the roll mold and was arranged in a hexagonal alignment manner at the minimum interval of 10 µm. The ratio of the area of the bottom surface portion of the spherical projections to the area of the light extraction film (the occupancy of the recessed and projected structure) was 73%.

### (Production of Surface Light-Emitting Body)

On the light emitting surface side of the EL element, Cargille standard refractive index liquid (refractive index of 1.52, manufactured by MORITEX Corporation) was coated as an adhesive layer, and the surface of the base material attached to the obtained light extraction film was subjected to optical adhesion to thereby obtain a surface light-emitting body. The light extraction efficiency, the luminance in the normal direction, and the amount of chromatic variation of the obtained surface light-emitting body are shown in Table 2.

Incidentally, an EL element in which the light extraction film on the surface of the light emitting surface side of Symfos OLED-010K (manufactured by KONICA MINOLTA, INC., white OLED element) is removed was used as an EL element.

### [Examples 14 to 18]

A light extraction film and a surface light-emitting body were obtained by performing the same operation as in Example 13, except that the content ratio of the ultraviolet absorber and the content ratio of the photo-stabilizing agent were changed as shown in Table 2. The evaluation results of the obtained surface light-emitting body are shown in Table 2.

Incidentally, a hindered amine compound (trade name "Tinuvin 123," manufactured by BASF) was used as a photo-stabilizing agent.

### [Reference Example 2]

The EL element used in Example 13, that is, the EL element in which the light extraction film on the surface of the light emitting surface side of Symfos OLED-010K (manufactured by KONICA MINOLTA, INC., white OLED element) is removed was used as a surface light-emitting body without any change.

Incidentally, the refractive index of the glass substrate of the EL element was 1.50.

**[Table 2]**

| | Active Energy ray curable monomer composition | | | Evaluation result of surface light-emitting body | | | | | | | | |
|---|---|---|---|---|---|---|---|---|---|---|---|---|
| | Content ratio of ultraviolet absorber (%) | Content ratio of photo-stabilizing agent(%) | Refractive index of cured product | Before ultraviolet ray irradiation (before accelerated deterioration test) | | | After ultraviolet ray irradiation (after accelerated deterioration test) | | | Difference between before and after ultraviolet ray irradiation (difference between before and after accelerated deterioration test) | | |
| | | | | Light extraction efficiency (%) | Luminance in normal direction (%) | Amount of chromatic variation | Light extraction efficiency (%) | Luminance in normal direction (%) | Amount of chromatic variation | Light extraction efficiency (%) | in normal direction (%) | Amount of chromatic variation |
| Reference Examples 2 | - | - | - | 100 | 100 | 0,0124 | - | - | - | - | - | - |
| Example 13 | 5 | 0 | 1,58 | 180.0 | 162,9 | 0,0082 | 179,7 | 161,1 | 0.0080 | -0,31 | -1.80 | -0,0002 |
| Example 14 | 10 | 0 | 1,58 | 179,5 | 158.0 | 0.0080 | 179,5 | 157,8 | 0,0079 | -0,07 | -0,23 | -0,0001 |
| Example 15 | 15 | 0 | 1,58 | 178,9 | 155,5 | 0,0078 | 178,6 | 155,4 | 0,0078 | -0,37 | -0,11 | 0.0000 |
| Example 16 | 0 | 1 | 1,58 | 180,1 | 163.0 | 0,0085 | 179,7 | 160,8 | 0.0080 | -0,37 | -2,22 | -0,0005 |
| Example 17 | 0 | 3 | 1,58 | 180,1 | 164,7 | 0,0084 | 178,6 | 162.0 | 0.0080 | -1,44 | -2,78 | -0,0004 |
| Example 18 | 0 | 10 | 1,58 | 175,6 | 162,6 | 0,0038 | 170,9 | 157,2 | 0,0035 | -4,75 | -5,41 | -0,0003 |

Regarding the surface light-emitting bodies obtained in Examples 13 to 18, it was possible to improve the light extraction efficiency and the luminance in the normal direction and to suppress the emission angle dependence of the wavelength of emitted light. Furthermore, regarding the surface light-emitting bodies obtained in Examples 13 to 18, it was found that a change in optical characteristics before and after the ultraviolet ray irradiation (before and after the accelerated deterioration test) can be suppressed and the long-term stability is excellent.

### INDUSTRIAL APPLICABILITY

According to the light extraction film of the invention, it is possible to obtain a surface light-emitting body which is excellent in light extraction efficiency and luminance in the normal direction and excellent in suppression of the emission angle dependence of the wavelength of emitted light, and this surface light-emitting body can be used suitably for, for example, lighting devices, displays, or screens.

Furthermore, when at least one of an ultraviolet absorber and a photo-stabilizing agent is used, the light extraction film of the invention has sufficiently improved light extraction efficiency and luminance in the normal direction of the surface light-emitting body and sufficiently suppressed emission angle dependence of the wavelength of emitted light, and is excellent in the long-term stability by suppression of a change in color due to ultraviolet ray exposure. Therefore, the surface light-emitting body using the light extraction film of the invention can be used suitably for, for example, lighting devices, displays, or screens.

### EXPLANATIONS OF LETTERS OR NUMERALS

- 10: LIGHT EXTRACTION FILM
- 11: RECESSED AND PROJECTED STRUCTURE LAYER
- 12: BASE LAYER
- 13: RECESSED AND PROJECTED STRUCTURE
- 14: BASE MATERIAL
- 15: BOTTOM SURFACE PORTION OF RECESSED AND PROJECTED STRUCTURE
- 21: ADHESIVE LAYER
- 22: PROTECTIVE FILM
- 30: EL ELEMENT
- 31: GLASS SUBSTRATE
- 32: POSITIVE ELECTRODE
- 33: LIGHT EMITTING LAYER
- 34: NEGATIVE ELECTRODE
- 50: APPARATUS
- 51: MONOMER COMPOSITION
- 52: ROLL MOLD
- 53: NIP ROLL
- 54: ACTIVE ENERGY RAY IRRADIATION APPARATUS
- 55: TANK
- 56: PIPE

## Claims

1. A light extraction film which is laminated on a substrate of an EL element, wherein
the light extraction film has a recessed and projected structure on the surface thereof, and
a material constituting the light extraction film contains a resin (X) having at least one skeleton of a fluorene skeleton, a biphenyl skeleton, and a naphthalene skeleton.

2. The light extraction film according to claim 1, wherein the resin (X) contains a constituent unit represented by the following Formula (1).

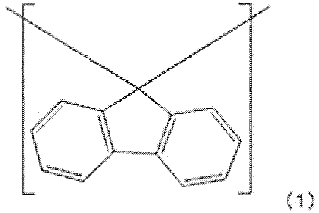

3. The light extraction film according to claim 1 or 2, wherein the resin (X) contains a constituent unit represented by the following Formula (4). 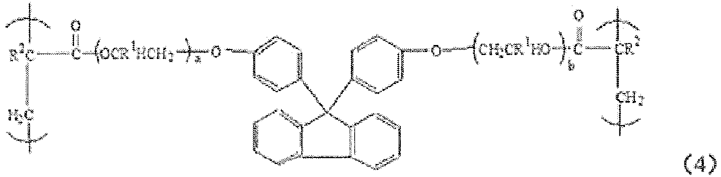 (In the formula, R¹ and R² each independently represent a hydrogen atom or a methyl group, and a and b each independently represent an integer of 0 to 4.)

4. The light extraction film according to any one of claims 1 to 3, wherein a content ratio of the resin (X) in the material constituting the light extraction film is 50% by mass or more.

5. The light extraction film according to any one of claims 1 to 4, wherein a ratio (A1/A2) of a peak area (A1) derived from aromatic series to a peak area (A2) derived from other than the aromatic series when the light extraction film is measured by ¹³C-NMR is 0.1 or more.

6. The light extraction film according to any one of claims 1 to 5, wherein a refractive index of the light extraction film is 1.55 to 1.65.

7. The light extraction film according to any one of claims 1 to 6, wherein the resin (X) contains at least one constituent unit of a polyoxyalkylene glycol di(meth)acrylate unit, a polyester polyol di(meth)acrylate unit, and an aromatic ester diol di(meth)acrylate unit.

8. The light extraction film according to any one of claims 1 to 7, wherein a shape of the recessed and projected structure is at least one of a spherical segment shape, a spherical segment trapezoidal shape, an ellipsoid spherical segment shape, an ellipsoid spherical segment trapezoidal shape, a pyramid shape, and a pyramid trapezoidal shape.

9. The light extraction film according to any one of claims 1 to 8, wherein a shape of the recessed and projected structure is at least one of a spherical segment shape and an ellipsoid spherical segment shape, and an occupancy of the recessed and projected structure is 70 to 90%.

10. The light extraction film according to any one of claims 1 to 9, wherein a content ratio of light diffusion fine particles in the material constituting the light extraction film is 20% by mass or less.

11. The light extraction film according to any one of claims 1 to 10, wherein the material constituting the light extraction film contains an ultraviolet absorber.

12. The light extraction film according to any one of claims 1 to 11, wherein the material constituting the light extraction film contains a photo-stabilizing agent.

13. A surface light-emitting body comprising the light extraction film according to any one of claims 1 to 12 and an EL element.

14. The surface light-emitting body according to claim 13, further comprising a polyester resin base material between the light extraction film and the EL element.

15. The surface light-emitting body according to claim 13 or 14, wherein a substrate of the EL element is glass having a refractive index of 1.45 to 1.55.

16. The surface light-emitting body according to any one of claims 13 to 15, further comprising an adhesive layer between the light extraction film and the EL element, wherein
a refractive index of the adhesive layer is 1.48 to 1.58.

17. The surface light-emitting body according to any one of claims 13 to 16, wherein an amount of chromatic variation of the surface light-emitting body is 0.01 or less.

18. A method for producing a light extraction film which is laminated on a substrate of an EL element, the method comprising:
supplying a monomer composition containing a monomer (x) having at least one skeleton of a fluorene skeleton, a biphenyl skeleton, and a naphthalene skeleton to a space between a base material and a mold having a transferring portion of a recessed and projected structure; and
curing the monomer composition.

19. The method for producing a light extraction film according to claim 18, wherein a content ratio of the monomer (x) in the monomer composition is 30% by mass or more.
